Europäisches Patentamt

(19) European Patent Office

Office européen des brevets

(11) Numéro de publication : **0 109 037**
**B1**

(12) **FASCICULE DE BREVET EUROPÉEN**

(45) Date de publication du fascicule du brevet :
02.03.88

(51) Int. Cl.⁴ : **G 01 R 29/26, H 04 J 3/17**

(21) Numéro de dépôt : **83111149.7**

(22) Date de dépôt : **08.11.83**

(54) **Procédé et dispositif d'évaluation du niveau de bruit sur une voie téléphonique.**

(30) Priorité : **10.11.82 FR 8218854**

(43) Date de publication de la demande :
**23.05.84 Bulletin 84/21**

(45) Mention de la délivrance du brevet :
**02.03.88 Bulletin 88/09**

(84) Etats contractants désignés :
**BE DE FR GB IT LU NL**

(56) Documents cités :
**EP-A- 0 036 354**
**US-A- 4 074 201**
**US-A- 4 351 983**
**US-A- 4 357 491**
**COMSAT TECHNICAL REVIEW, vol. 6, no. 1, 1976, pages 159-178, Communications Satellite Corp., Washington, DC, US J.A. JANKOWSKI JR.: "A new digital voice-activated switch**

(73) Titulaire : **ALCATEL CIT**
**33, rue Emeriau**
**F-75015 Paris (FR)**

(72) Inventeur : **de Bergh, Guy**
**6, avenue de Brimont**
**F-78400 Chatou (FR)**

(74) Mandataire : **Weinmiller, Jürgen et al**
**Lennéstrasse 9 Postfach 24**
**D-8133 Feldafing (DE)**

EP 0 109 037 B1

Jouve, 18, rue St-Denis, 75001 Paris, France

**Description**

La présente invention est relative à la transmission téléphonique et concerne l'évaluation du niveau de bruit sur une voie téléphonique. Elle vise plus particulièrement à résoudre le problème d'une telle évaluation à partir des signaux présents sur la voie en service, c'est-à-dire à partir de signaux constitués de signaux de parole (ou de signalisation) auxquels se superpose le bruit, séparés par des intervalles de silence occupés par le seul bruit.

On trouve une application particulière de l'invention dans la détection de parole, par exemple dans un dispositif de concentration de signaux téléphoniques par interpolation de la parole, ou bien encore dans la génération de bruit dit d'agrément destiné, dans un réseau téléphonique où les chemins de transmission entre abonnés en communication sont temporairement interrompus, par exemple à des fins de suppression d'écho ou de concentration, à limiter la perception de ces interruptions par les abonnés.

On sait que les dispositifs de concentration de signaux téléphoniques par interpolation de la parole, qui équipent certaines liaisons téléphoniques multivoie, augmentent les capacités de ces liaisons en évitant la transmission des silences des conversations. Ils comportent donc des détecteurs de parole pour repérer les périodes de parole et les périodes de silence sur chacune des voies à concentrer. Les performances de ces dispositifs de concentration sont directement tributaires de la qualité de la discrimination parole/silence effectuée par ces détecteurs de parole. En particulier, il est souhaitable que ces détecteurs de parole présentent une grande insensibilité au bruit afin de permettre un taux de concentration élevé, tout en étant très sensibles aux signaux de parole afin d'éviter un hachage de la parole.

Il est connu de détecter un signal de parole sur une voie de transmission téléphonique à partir essentiellement du niveau du signal présent sur la voie surveillée. Ainsi, tout signal sur la voie surveillée dont le niveau sur un intervalle de temps est supérieur à un seuil placé au-dessus du niveau de bruit sur la voie est présumé être un signal de parole et le reste du silence. En vue d'effectuer une telle détection de signal de parole sur une voie, il est connu d'élaborer un signal représentatif du niveau moyen sur un intervalle de temps élémentaire du signal présent sur la voie et de comparer ce signal élaboré à un seuil supérieur au niveau de bruit sur la voie. En vue d'effectuer une telle détection de signal de parole sur une voie, il est également connu de comparer l'amplitude de chaque échantillon du signal présent sur la voie surveillée, échantillonné à la cadence de 8 kHz, à un seuil supérieur au niveau de bruit sur la voie, d'attribuer à chaque échantillon une note algébrique fonction du résultat de la comparaison et de cumuler les notes attribuées aux échantillons successifs afin d'effectuer la discrimination parole/silence à partir de ce cumul.

Il est parfois pris comme référence de niveau de bruit, en vue de la détermination du seuil de comparaison intervenant dans une telle détection de signal de parole, le niveau maximal de bruit admis par le CCITT pour une voie téléphonique, soit — 40 dBmo. Toutefois, le niveau de bruit sur une voie téléphonique peut différer sensiblement de cette valeur et une meilleure discrimination parole/silence peut être obtenue en évaluant le niveau de bruit sur la voie surveillée et faisant varier le seuil de comparaison en fonction du niveau de bruit évalué, ainsi qu'il a été aussi déjà proposé.

L'évaluation du niveau de bruit sur une voie téléphonique est également utile pour la génération de bruit d'agrément dans certains réseaux téléphoniques. Ainsi, on sait qu'au cours d'une communication téléphonique passant sur un circuit quatre fils muni de suppresseurs d'écho, lorsqu'un seul des abonnés en communication parle, la voie que définit le circuit quatre fils pour la transmission dans le sens de l'abonné récepteur qui se tait vers l'abonné qui parle est coupée en vue de bloquer la propagation de signaux d'écho. Il est connu d'injecter alors sur cette voie, en aval de la coupure, un bruit d'agrément destiné à compenser la contribution au bruit de fond normalement perçu par l'abonné récepteur pour ce sens de transmission, des équipements du réseau desquels cet abonné est déconnecté du fait de cette coupure. Une évaluation du niveau de cette contribution et une adaptation du niveau du bruit d'agrément au résultat de cette évaluation permettent d'obtenir une bonne compensation en niveau et, par la-même, de limiter sensiblement la perception de telles coupures qui nuirait au bon déroulement de la conversation.

Le problème de limitation de la perception des interruptions temporaires des chemins de transmission entre abonnés en communication se pose également, ainsi qu'on le sait, dans les réseaux téléphoniques équipés de dispositifs de concentration par interpolation de la parole. Dans de tels dispositifs, l'évaluation du niveau de bruit sur une voie peut être utilisée à la fois à des fins de détection de parole et à des fins de génération de bruit d'agrément.

Le problème essentiel à résoudre, lorsque l'on veut évaluer le niveau du bruit sur une voie téléphonique à partir des signaux présents sur la voie en service, est d'éviter que les signaux de parole acheminés par cette voie, dont certains peuvent être de niveau très faible, ne faussent l'opération. Pour résoudre ce problème, il est provoqué dans le document FR-A 2 451 680, qui décrit un circuit d'évaluation du niveau de bruit sur une voie téléphonique intégré au sein d'un détecteur de parole, d'utiliser deux filtres de moyenne, un premier à bande relativement étroite et un second à bande très étroite. Ces deux filtres traitent le signal présent sur la voie en traitement pendant les périodes de silence repérées par le détecteur de parole ; le premier traite en outre le signal présent sur cette voie pendant les périodes

0 109 037

d'activité repérées par le détecteur de parole tandis que le second est alors constamment initialisé au double de la valeur du signal de sortie du premier. Le niveau de bruit sur la voie est évalué à la dernière valeur commune de convergence de ces deux filtres. Une telle façon de procéder se fonde sur le fait que le bruit de fond sur une voie téléphonique est généralement assez stationnaire à l'opposé des signaux de parole qui présentent un caractère non stationnaire. Dans ces conditions, les deux filtres, dont les constantes de temps équivalentes sont voisines respectivement de 8 ms et 0,128 ms, ne convergent vers une même valeur que lorsqu'un bruit de fond a été seul présent sur la voie pendant une durée relativement longue ; cette valeur commune de convergence traduit alors le niveau moyen de bruit.

Pour résoudre ce même problème, une autre solution, se fondant également sur ces caractères différents des signaux de parole et du bruit de fond sur une voie téléphonique, est décrite dans le document FR-A 2 482 389. Selon ce document, un circuit de calcul de moyenne élabore une représentation du niveau moyen du signal présent sur la voie en traitement sur un intervalle de temps élémentaire. Deux circuits de prélèvement et d'enregistrement extraient et conservent l'un la valeur maximale l'autre la valeur minimale de cette représentation, ces deux circuits étant réinitialisés à une même cadence variable de période longue par rapport à l'intervalle élémentaire. Un comparateur compare entre elles les valeurs maximale et minimale fournies par les deux circuits de prélèvement et d'enregistrement, afin de repérer les moments où ces deux valeurs satisfont à une relation donnée traduisant un faible écart relatif entre elles. Le niveau de bruit est alors obtenu à partir des valeurs minimales de la représentation pour lesquelles cette relation est satisfaite. Pour ces opérations, la constante de temps équivalente du circuit de calcul de moyenne est de 16 ms et la réinitialisation des deux circuits de prélèvement et d'enregistrement s'effectue à une cadence plus rapide lorsque la voie est présumée être inactive que lorsque celle-ci est présumée être active, toutes les 256 ms et toutes les 2 s respectivement, ces états présumés de la voie correspondant à des états d'une machine séquentielle dont l'évolution s'effectue sous la commande de paramètres fonction de la représentation du niveau moyen du signal présent sur la voie, dans la détermination desquels intervient le niveau de bruit évalué.

Avec l'une ou l'autre de ces deux solutions, l'évaluation du niveau de bruit ne se fait qu'au cours des intervalles de silence assez longs. Ceci peut conduire à des temps d'acquisiton très grands, tout particulièrement dans le cas où se propagent sur la voie non seulement des signaux de parole d'un abonné émettant dans cette voie mais également des signaux d'écho des signaux de parole du correspondant de cet abonné, l'évaluation du niveau de bruit ne se faisant alors que lorsque les deux abonnés se taisent pendant une durée appréciable. De plus ces deux solutions impliquent un repérage des périodes de parole et de silence faisant appel à des agencements complexes, lourds dans le cadre d'une application autre que la détection de parole.

La présente invention a pour but de remédier à ces inconvénients en permettant une évaluation rapide et précise du niveau de bruit sur une voie téléphonique au moyen d'un agencement simple.

Elle a pour objet un procédé d'évaluation du niveau de bruit sur une voie téléphonique, à partir de l'évaluation du niveau du signal présent sur cette voie sur des intervalles de temps successifs sensiblement de même durée, consistant à :

— attribuer au niveau de bruit sur cette voie une plage donnée de valeurs possibles, définie à partir d'une valeur de niveau maximal de bruit admis sur la voie, dite plage de niveau de bruit dans laquelle s'étend un ensemble défini limité de valeurs discrètes de niveau,

— sélectionner les valeurs successives de niveau de signal présent sur la voie sur lesdits intervalles de temps et tombant dans ladite plage de niveau de bruit

— et tenir une comptabilité relative des différentes valeurs sélectionnées exprimées à l'aide desdites valeurs discrètes pour prendre comme représentative du niveau de bruit sur la voie celle des valeurs discrètes sur laquelle se concentre la majorité des valeurs de signal sélectionnées.

Avantageusement, dans la comptabilité relative des valeurs sélectionnées, chaque valeur sélectionnée est pondérée plus ou moins fortement selon qu'elle est égale ou non à la valeur courante du niveau de bruit évalué.

La présente invention a également pour objet un dispositif de mise en œuvre du procédé précité. Ce dispositif comporte :

— un circuit d'évaluation du signal présent sur la voie téléphonique sur les intervalles de temps successifs I sensiblement de même durée,

— un circuit de sélection sélectionnant, parmi les valeurs de niveau de signal présent sur la voie qu'il reçoit du circuit d'évaluation, les seules valeurs comprises dans ladite plage de niveau de bruit et les délivrant exprimées à l'aide d'un ensemble limité défini de r valeurs discrètes,

— un circuit d'analyse des valeurs sélectionnées délivrées par le circuit de sélection, sensible à la répartition desdites valeurs sélectionnées entre lesdites valeurs discrètes, repérant celle des valeurs discrètes sur laquelle se concentre la majorité des valeurs sélectionnées pour la délivrer sur une sortie en tant que valeur représentative du niveau de bruit,

— et un circuit de cadencement des circuits d'évaluation et de sélection de niveau de signal présent sur la voie ainsi que du circuit d'analyse pour la détermination de la valeur du niveau de bruit au rythme desdits intervalles de temps I définis par ce circuit de cadencement.

Selon un mode particulier de réalisation, le circuit d'analyse des valeurs sélectionnées comporte :

— une mémoire adressable adressée sous le contrôle d'un signal de séquence élaboré par ledit

3

circuit de cadencement, mémorisant pour les r valeurs discrètes r comptes respectivement traduisant la répartition des valeurs sélectionnées délivrées par le circuit de sélection entre les r valeurs discrètes,

— un circuit de calcul des comptes comportant d'une part un circuit de définition d'incrément de compte et d'autre part un circuit sommateur ayant deux entrées reliées à la sortie de la mémoire et à la sortie dudit circuit de définition d'incrément de compte respectivement et une sortie reliée à l'entrée de ladite mémoire,

— un circuit de commande comportant des circuits comparateurs comparant, pour chaque valeur sélectionnée délivrée par le circuit de sélection, d'une part les différentes valeurs discrètes reçues en concordance avec l'adressage de ladite mémoire avec la valeur sélectionnée considérée pour identifier le compte mémorisé concerné par cette valeur sélectionnée et d'autre part les différents comptes mémorisés avec un seuil haut et un seuil bas de compte préétablis, commandant, dans ledit circuit de définition d'incrément de compte, pour chaque valeur sélectionnée délivrée par le circuit de sélection, le choix d'une valeur d'incrément positive pour le seul compte concerné par la valeur sélectionnée considérée si celui-ci ne dépasse pas ledit seuil haut ou d'une valeur d'incrément négative pour les autres comptes supérieurs audit seuil bas si ce compte concerné par la valeur sélectionnée considérée dépasse ledit seuil haut

— et un circuit de sortie de la valeur de niveau de bruit commandé par ledit circuit de commande lors de la détection du dépassement dudit seuil haut par l'un des comptes mémorisés, recevant la valeur discrète concernée par ce compte dépassant ledit seuil haut.

Les caractéristiques et avantages de la présente invention apparaîtront plus clairement au cours de la description d'un mode de réalisation donné à titre d'exemple et illustré dans les dessins joints. Dans ces dessins :

— la figure 1 est un diagramme synoptique d'un dispositif d'évaluation de niveau de bruit selon l'invention,

— la figure 2 est un schéma d'un circuit d'évaluation et de sélectionner des valeurs du niveau de signal sur la voie, utilisé dans la figure 1,

— la figure 3 est un schéma d'un circuit d'analyse des valeurs sélectionnées du niveau de signal sur la voie, utilisé dans la figure 1,

— la figure 4 est un schéma d'un circuit de cadencement, également utilisé dans la figure 1,

— la figure 5 illustre dans le temps, des signaux délivrés par le circuit de cadencement utilisé dans la figure 1 et donné dans la figure 4.

Le dispositif d'évaluation du niveau de bruit illustré dans les dessins est de type numérique. Il est prévu pour traiter un signal de voie téléphonique disponible sous forme d'échantillons numériques successifs. Pour la simplicité de la présentation, il ne traite qu'une seule voie. Bien entendu, il pourrait être adapté au traitement en temps partagé d'une pluralité de voies.

Pour des raisons de simplicité de présentation également, dans ces figures les liaisons acheminant des signaux numériques définis par des mots binaires à plusieurs bits en parallèle ont été représentées par un trait fort, plus épais que celles acheminant des signaux binaires. Le nombre de bits en parallèle transmis sur ces liaisons en trait fort sera précisé au fur et à mesure de la description des figures, donnée en regard d'exemples chiffrés.

On précise encore qu'il est utilisé dans la description ci-après des références constituées d'une lettre affectée d'un indice ; par commodité la lettre et l'indice de telles références apparaissent dans les figures au même niveau.

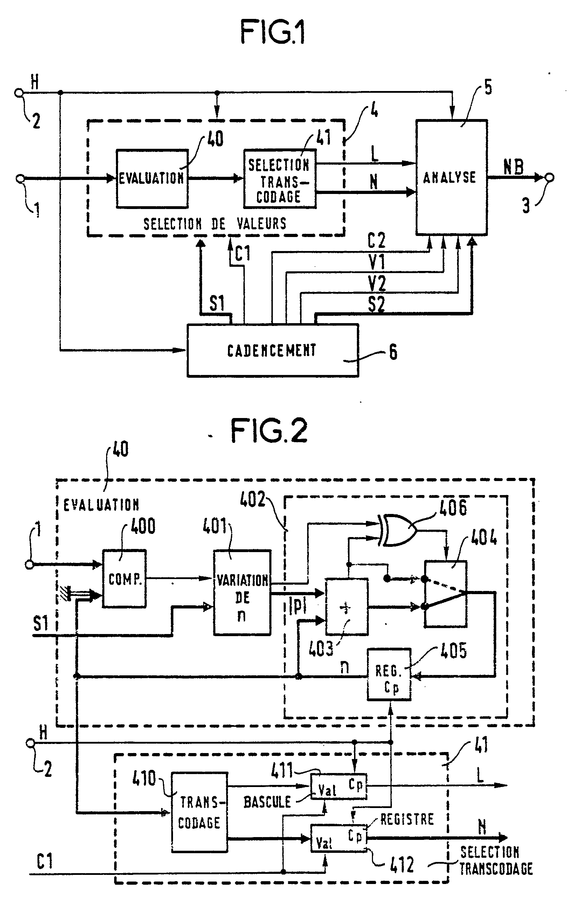

Le dispositif selon l'invention illustré dans la figure 1 présente une entrée 1 sur laquelle sont appliqués en parallèle les bits définissant l'amplitude des échantillons numériques du signal présent sur une voie téléphonique à traiter, indépendamment de la polarité de ces échantillons, une entrée 2 sur laquelle est appliqué un signal d'horloge H à la cadence d'échantillonnage et une sortie 3 sur laquelle est disponible la valeur du niveau de bruit évalué, soit NB, également définie sous forme numérique. Il comporte un circuit 4 d'évaluation et de sélection des valeurs du niveau du signal présent sur la voie, relié à ses deux entrées 1 et 2, un circuit 5 d'analyse des valeurs sélectionnées délivrées par le circuit 4, disposé à la suite de ce circuit 4 et relié, en outre, à l'entrée 2 pour recevoir le signal d'horloge H, fournissant la valeur du niveau de bruit évalué NB sur la sortie 3, et un circuit 6 de cadencement élaborant à partir du signal d'horloge H qu'il reçoit de l'entrée 2 différents signaux de cadencement précisés ci-après, qui sont nécessaires au bon fonctionnement des circuits 4 et 5.

Le circuit 4 évalue le niveau du signal présent sur la voie téléphonique sur des intervalles de temps I successifs de même durée, longue par rapport à la période du signal d'horloge H à la cadence d'échantillonnage, et sélectionne celles des valeurs de niveau de ce signal tombant dans une plage donnée P considérée comme la plage des valeurs possibles de niveau de bruit et dite plage de niveau de bruit. Il fournit, sur une première sortie, un signal logique L indiquant pour chaque valeur de niveau de ce signal si celle-ci tombe ou non dans la plage P et, sur une deuxième sortie, chacune des valeurs de niveau de ce signal tombant dans la plage P, ces valeurs tombant dans la plage P et désignées par N étant exprimées à l'aide d'un ensemble limité de r différentes valeurs désignées $N_0$ à $N_{r-1}$. Pour ce faire, le circuit 4 se compose d'un circuit d'évaluation de niveau 40 qui reçoit les bits des échantillons appliqués à l'entrée 1 c'est-à-dire des échantillons du signal présent sur la voie téléphonique, et d'un circuit de sélection 41 qui reçoit les valeurs de niveau élaborées par le circuit 40 et sélectionne celles des valeurs

4

qui tombent dans la plage P. Le circuit 40 évaluant le niveau du signal présent sur la voie, en ce qui concerne la plage P, à l'aide ici d'un ensemble de valeurs en nombre supérieur à r, le circuit de sélection 41 assure en outre ici un transcodage des valeurs qu'il sélectionne, permettant de les exprimer à l'aide des r valeurs $N_0$ à $N_{r-1}$.

Le circuit 4 reçoit du circuit de cadencement 6 un signal de cadencement $C_1$ définissant les intervalles I et un signal de séquence $S_1$ définissant des séquences identiques $s_1$ chacune se déroulant sur tout un intervalle I et y définissant différentes phases de fonctionnement du circuit 4 qui seront précisées ci-après au cours de la description détaillée de ce circuit donnée en regard de la figure 2.

Ces intervalles de temps I sur lesquels s'effectue l'évaluation du niveau du signal présent sur la voie téléphonique sont de durée choisie longue par rapport à la période de la fréquence limite inférieure de la bande passante, soit longue par rapport à 1/300 s ≈3,3 ms, et courte par rapport au temps moyen d'établissement ou chute des syllabes qui est de l'ordre d'une quarantaine de millisecondes.

Le circuit 5 d'analyse des valeurs sélectionnées N qu'il reçoit du circuit 4 est sensible à leur répartition entre les différentes valeurs $N_0$ à $N_{r-1}$. La majorité de ces valeurs sélectionnées N est en fait généralement concentrée sur l'une des valeurs $N_0$ à $N_{r-1}$ et c'est cette dernière valeur qui est repérée par le circuit 5 et considérée comme significative du niveau de bruit sur la voie. En effet, lorsque le signal présent sur la voie téléphonique n'est constitué que d'un bruit de fond, l'évaluation faite par le circuit 4 du niveau de ce signal fournit des valeurs de niveau qui tombent dans la plage P et sont donc sélectionnées et qui s'avèrent très peu dispersées (du fait du caractère quasi « stationnaire » du bruit), en général concentrées principalement sur l'une des valeurs $N_0$ à $N_{r-1}$ et secondairement sur les deux valeurs adjacentes ou le cas échéant l'unique valeur adjacente à celle-ci. Lorsque, par contre, un signal de parole se superpose au bruit, les valeurs de niveau du signal sur la voie téléphonique, qui soit tombent hors de la plage de niveau P et sont donc ignorées par le circuit 5 soit tombent dans la plage P mais s'avèrent très dispersées (du fait du caractère « non stationnaire » des signaux de parole), n'arrivent pas à renverser une majorité établie antérieurement. La voie téléphonique achemine également à certains moments des signaux de signalisation ; ceux-ci sont des signaux à très haut niveau et ne risquent pas d'agir de manière significative sur les calculs de répartition effectués par le circuit 5.

. Ce circuit 5 effectue une comptabilisation relative des valeurs sélectionnées N qui sont exprimées par les différentes valeurs $N_0$ à $N_{r-1}$. Il dénombre les valeurs sélectionnées N exprimées par chacune de ces différentes valeurs $N_0$ à $N_{r-1}$ et fait évoluer relativement les uns par rapport aux autres les r comptes résultants pour chaque nouvelle valeur sélectionnée N qu'il reçoit du circuit 4. Pour cette évolution relative, le circuit 5 prend en considération la position du compte concerné par la nouvelle valeur sélectionnée N reçue par rapport à un seuil haut fixé pour tous les comptes et, le cas échéant, prend aussi en considération les positions de tous les autres comptes par rapport à un seuil bas fixé pour tous les comptes : si le compte concerné par cette nouvelle valeur sélectionnée ne dépasse pas ce seuil haut, il augmente ce compte concerné d'une certaine quantité tandis que les autres comptes demeurent inchangés, si par contre le compte concerné par cette nouvelle valeur dépasse déjà ce seuil haut, ce compte concerné demeure inchangé tandis que ceux des autres comptes supérieurs au seuil bas donné pour tous les comptes sont diminués d'une certaine quantité.

En général, un seul de ces r comptes effectués par le circuit 5 dépasse le seuil haut donné et c'est la valeur de niveau de signal concernée par ce compte qui constitue la valeur de niveau de bruit évalué NB délivrée par l'ensemble 5. Toutefois, il peut se produire parfois, en particulier suite à un changement de niveau de bruit, que le seuil haut soit dépassé par plus d'un compte ; dans ce cas, le circuit 5 sélectionne selon un mode donné l'une des valeurs de niveau de signal concernées par ces comptes en question ; c'est ici la plus grande de ces valeurs concernées qui est retenue pour être délivrée en sortie de ce circuit.

Le circuit 5 reçoit du circuit de cadencement 6 un signal de séquence $S_2$ déterminant à l'intérieur de chaque intervalle I une pluralité de séquences identiques $s_2$ chacune de r périodes du signal d'horloge H, en vue de l'exécution en série, dans chaque intervalle I, d'opérations concernant les r valeurs $N_0$ à $N_{r-1}$. Il reçoit aussi de ce même circuit de cadencement 6, deux signaux $V_1$ et $V_2$ ayant des périodes de même durée que celle des intervalles I, tous deux de même forme et repérant dans chaque intervalle I respectivement deux des séquences $s_2$ au cours desquelles le circuit 5 effectue tous les traitements à exécuter dans cet intervalle. Il reçoit, en outre, du circuit de cadencement, un signal $C_2$ de même forme que le signal $C_1$ mais retardé par rapport à ce dernier pour tenir compte des temps de traitement.

Les différents circuits et signaux apparaissant dans la figure 1 sont détaillés ci-après. Dans la suite de la description, on a considéré que les bascules, registres et compteurs que comportent ces circuits sont sensibles aux fronts montants des signaux appliqués à leurs entrées horloge et que les bascules et registres prennent alors en compte les niveaux logiques qui étaient présents sur leurs autres entrées juste avant l'apparition de ces fronts. On a considéré de plus que les changements d'échantillons du signal sur la voie téléphonique s'effectuent sur les fronts montants du signal d'horloge H.

On précise, à titre d'exemple en particulier pour la suite de la description, que r est choisi égal à 16 et que les 16 valeurs $N_0$ à $N_{15}$ s'étendent régulièrement espacées en dB sur la plage de niveau de bruit allant sensiblement de — 55 dBmo à — 35 dBmo. La durée des intervalles de temps I est choisie égale à 16 ms. Le signal sur la voie téléphonique, échantillonné à cadence de 8 kHz, est supposé codé en MIC sur 8 bits dont 7 pour l'amplitude et le 8e pour le signe, avec par exemple la loi de compression A = 87,6 selon laquelle, parmi les 128 niveaux de codage représentés par les 7 bits d'amplitude, les 32 niveaux les plus faibles correspondent à la plage des valeurs d'amplitude inférieure à — 33 dBmo : il est précisé, toutefois, que le circuit d'évaluation de niveau 40 peut s'accommoder d'une autre loi, par exemple de la $\mu$ = 255.

Dans la figure 2, on a détaillé le circuit 4 composé du circuit d'évaluation de niveau 40 et du circuit de sélection 41.

Le circuit d'évaluation de niveau 40 est constitué d'une boucle d'asservissement comportant un comparateur 400, un circuit 401 de définition de la variation de la valeur n d'un niveau de comparaison à appliquer au comparateur 400 et un accumulateur 402 cumulant des pas de variation p définis par le circuit 401.

Le comparateur 400 reçoit, sur une première entrée formant l'entrée du circuit 40 reliée à l'entrée 1 du dispositif, la valeur à 7 bits (de poids $2^0$ à $2^6$) de l'amplitude des échantillons successifs du signal présent sur la voie téléphonique. Il reçoit sur une deuxième entrée la valeur du niveau variable de comparaison n qui sera délivrée sur la sortie du circuit 40. En réponse à ces deux signaux d'entrée, il délivre un signal logique indiquant par son niveau « 1 » ou « 0 » si la valeur de l'échantillon actuel du signal présent sur la voie téléphonique est supérieure ou non à la valeur de comparaison n.

Le circuit 401 de définition de la variation de la valeur du niveau de comparaison n est connecté à la sortie du comparateur 400. Il reçoit, outre le signal logique délivré par le comparateur, le signal de séquence $S_1$ pour définir le pas de variation p de la valeur de comparaison n, qui sera positif ou négatif selon que le signal logique de sortie du comparateur est au niveau « 1 » ou « 0 », et dont la valeur absolue est déterminée par le signal $S_1$ et va sur chaque intervalle I en diminuant au fur et à mesure que se déroule la séquence $s_1$.

On précise à titre indicatif dans le tableau I ci-après une loi de variation de la valeur absolue du pas de variation p, cette valeur absolue exprimée numériquement évoluant par exemple de 2 (soit $2^1$) à 1/8 (soit $2^{-3}$) au cours de chaque intervalle I découpé en 8 sous-intervalles de 2 ms numérotés de 0 à 7 par la séquence $s_1$ qui s'y déroule.

Tableau I

| Sous-intervalle de I | 0 | 1 | 2 | 3 | 4 | 5 | 6 | 7 |
|---|---|---|---|---|---|---|---|---|
| Valeur absolue de p | 2 | 1 | 1/2 | 1/2 | 1/4 | 1/4 | 1/8 | 1/8 |

Le circuit 401, qui peut être constitué par une mémoire de type PROM, définit les pas de variation p sur 9 bits dont un pour le signe, de valeur 1 pour le signe + et de valeur 0 pour le signe —, et huit pour la valeur absolue, de poids respectifs $2^{-3}$ à $2^4$ en exprimant la valeur absolue des pas négatifs par son complément à $2^5$, ce qui permet, ainsi qu'il est bien connu de remplacer des soustractions par des additions dans les calculs à réaliser.

L'accumulateur 402 est connecté à la sortie du circuit 401 et reçoit par ailleurs le signal d'horloge H. Il cumule à la cadence d'échantillonnage, entre une butée inférieure et une butée supérieure, les pas de variation p définis par le circuit 401 pour délivrer la valeur du niveau n fournie en sortie du circuit d'évaluation de niveau 40 et appliquée à la seconde entrée du comparateur.

On limite la capacité de cet accumulateur 402 à huit bits de poids respectifs $2^{-3}$ à $2^4$. Le contenu de l'accumulateur évolue donc de 0 à 31 + 7/8, ce qui représente une plage de niveau qui inclut la plage P de niveau de bruit en la débordant supérieurement ainsi en outre qu'inférieurement.

En pratique, sur les huit bits du contenu de l'accumulateur, seuls les cinq bits de plus forts poids sont appliqués à la seconde entrée du comparateur 400 qui reçoit, en outre, en permanence deux bits 0 sur les deux bornes affectées aux bits de poids $2^5$ et $2^6$ de cette seconde entrée.

L'accumulateur 402 peut être réalisé, ainsi que représenté, à l'aide d'un additionneur 403 à deux entrées à huits bits, d'un multiplexeur 404 à deux entrées de multiplexage également à 8 bits, d'un registre 405 à huit bits en parallèle et d'une porte logique « ou exclusif » 406 à deux entrées.

L'additionneur 403 reçoit sur l'une de ses entrées les huits bits de valeur absolue $|p|$ des pas successifs délivrés par le circuit 401 et sur son autre entrée les huit bits mémorisés dans le registre 405 qui définissent le contenu de l'accumulateur 402. La somme à huit bits délivrée par l'additionneur 403 est appliquée à une première entrée du multiplexeur 404. Ce multiplexeur a sa seconde entrée de multiplexage à 8 bornes connectées en commun ainsi que symbolisé dans la figure 2 à une sortie de propagation de retenue de l'additionneur 403. Il reçoit donc sur cette seconde entrée la valeur numérique 0 ou 31 + 7/8 selon le niveau logique « 0 » traduisant une retenue finale nulle ou « 1 » traduisant une retenue finale non nulle sur cette sortie de propagation de retenue. Le multiplexeur 404 reçoit, en outre, sur une entrée de commande d'adressage, le signal de sortie de la porte logique « ou exclusif » 406. Cette

0 109 037

porte reçoit sur l'une de ses entrées, le bit présent sur la sortie de propagation de retenue de l'additionneur 403 et sur l'autre entrée le bit de signe du pas délivré par le circuit 401 pour commander par le niveau « 1 » ou « 0 » de son signal de sortie la sélection de la première ou de la seconde entrée de multiplexage du multiplexeur 404. La sortie du multiplexeur est connectée à une entrée « donnée » du registre 405 qui reçoit, en outre, sur son entrée « horloge » $C_p$ le signal d'horloge H et dont la sortie constitue celle de l'accumulateur sur laquelle est délivrée la valeur du niveau de comparaison n.

En fonctionnement de cet accumulateur, lorsque, pour une période considérée du signal d'horloge H, la somme algébrique du contenu de l'accumulateur et de la valeur numérique du pas p n'est pas négative et n'excède pas 31 + 7/8, cette somme, appliquée sur la première entrée du multiplexeur, est inscrite dans le registre 405 au début de la période suivante du signal H. Dans ce cas, en effet, le niveau sur la sortie de propagation de retenue de l'additionneur 403 est « 0 » alors que le bit de signe du pas p vaut « 1 » ou inversement, le niveau sur la sortie de propagation de retenue est 1 alors que le bit de signe du pas vaut 0 ; le signal de sortie de la porte « ou exclusif » 406 est donc à « 1 » et commande la sélection de la première entrée de multiplexage du multiplexeur 404.

Lorsque, pour une période considérée du signal d'horloge H, la somme algébrique du contenu de l'accumulateur et de la valeur du pas p excède 31 + 7/8, ce qui se traduit par le fait que le niveau sur la sortie propagation de retenue est « 1 » alors que le bit de signe du pas vaut également « 1 », le signal de sortie de la porte 406, alors à « 0 », sélectionne la deuxième entrée de multiplexage du multiplexeur. Cette seconde entrée reçoit alors la valeur numérique 31 + 7/8 et c'est cette valeur qui est inscrite dans le registre 405 au début de la période suivante du signal d'horloge H.

Lorsque, dans le dernier cas possible, pour une période considérée du signal d'horloge H, la somme algébrique du contenu de l'accumulateur et de la valeur numérique du pas p est négative, ce qui se traduit par le fait que le niveau sur la sortie de propagation de retenue est « 0 » alors que le bit de signe du pas vaut également « 0 », le signal de sortie de la porte 406 alors à « 0 » sélectionne la seconde entrée de multiplexage et c'est la valeur 0 du signal sur la sortie de propagation de retenue qui est inscrite à travers le multiplexeur dans le registre 405 au début de la période suivante du signal H.

Le niveau n défini numériquement par le contenu de l'accumulateur 402 varie ainsi, à la cadence d'échantillonnage, par pas positifs ou négatifs selon que sa valeur est ou non inférieure à celle de l'amplitude des échantillons successifs du signal présent sur la voie téléphonique et de valeur absolue ne dépendant que du numéro des périodes d'échantillonnage concernées sur les intervalles I successifs en allant en diminuant sur chaque intervalle. Dans ces conditions, ce niveau variable n converge à la fin de chaque intervalle I, si l'on fait abstraction de l'écrêtage introduit par l'accumulateur 402 à capacité limitée, sensiblement vers une valeur dite d'équirépartition, c'est-à-dire telle que, sur cet intervalle, il y a autant d'échantillons du signal présent sur la voie dont l'amplitude lui est supérieure que d'échantillons dont l'amplitude lui est inférieure. Le niveau du signal présent sur la voie téléphonique est ainsi évalué, à la fin de chaque intervalle I, sensiblement à une valeur d'équirépartition, audit écrêtage près, cet écrêtage n'introduisant pas de limitation par la suite puisque l'on ne s'intéresse qu'aux valeurs de niveau situées dans la plage de niveau de bruit P.

Une telle façon d'évaluer le niveau du signal présent sur la voie téléphonique est particulièrement bien adaptée à une application à un détecteur de parole procédant, ainsi que précisé dans le préambule, par attribution à chaque échantillon du signal à analyser de notes fonction du résultat de la comparaison de cet échantillon à un seuil supérieur au niveau de bruit dans le cas où ce résultat n'intervient que par son signe. En variante toutefois, le niveau du signal présent sur la voie téléphonique sur chaque intervalle I pourrait être également évalué par exemple à la valeur moyenne de l'amplitude de ce signal ou bien encore à la valeur quadratique moyenne de l'amplitude de ce signal, en faisant varier en outre la valeur absolue du pas de variation de la valeur de niveau délivrée par la boucle d'asservissement proportionnellement à la valeur absolue ou au carré de la différence entre l'amplitude de l'échantillon du signal présent et cette valeur de niveau, avec éventuellement un facteur de proportionnalité allant en décroissant à l'intérieur de chaque intervalle I.

La sortie du circuit d'évaluation de niveau 40 est connectée à l'entrée d'un circuit de transcodage à seuils 410 du circuit de sélection 41. Ce circuit de transcodage d'une part sélectionne les valeurs de niveau n situées dans la plage de niveau de bruit P et d'autre part effectue un transcodage code linéaire à huit bits/code logarithmique à quatre bits des valeurs sélectionnées de manière à exprimer celles-ci à l'aide des valeurs $N_0$ à $N_{15}$, codées par exemple de 0 à 15 par ordre de valeurs croissantes. Il délivre sur une première sortie un signal logique indiquant par son niveau « 1 » ou « 0 » si la valeur du niveau n présente à son entrée tombe ou non dans la plage P et sur une seconde sortie la valeur transcodée à quatre bits correspondant à celle d'entrée si celle-ci est située dans la plage P, la valeur que délivre cette seconde sortie dans le cas contraire n'ayant aucune importance car elle ne sera pas prise en compte par le circuit d'analyse 5.

Le circuit de transcodage à seuils 410 peut être réalisé par exemple à l'aide d'une mémoire de type PROM.

Une bascule de type D411 est connectée à la première sortie du circuit à seuils 410 et un registre 412 à quatre bits en parallèle est connecté à la seconde sortie de ce circuit. La bascule 411 et le registre 412 sont cadencés par le signal d'horloge H appliqué à leur entrée horloge $C_p$ et validé par le signal $C_1$ appliqué à leur entrée validation d'horloge Val. Le signal $C_1$ est au niveau « 1 » pendant la première

7

période du signal d'horloge H du premier sous-intervalle de temps défini par chaque séquence $s_1$, c'est-à-dire pendant la première période du signal d'horloge H de chaque intervalle I, et au niveau « 0 » le reste du temps. On recueille ainsi à la sortie de la bascule 411, qui constitue la première sortie du circuit 4, le signal logique L, et à la sortie du registre 412, qui constitue la seconde sortie du circuit 4, les valeurs sélectionnées N, la présence d'une valeur sélectionnée à la sortie du registre 412 étant indiquée par le niveau « 1 » du signal L.

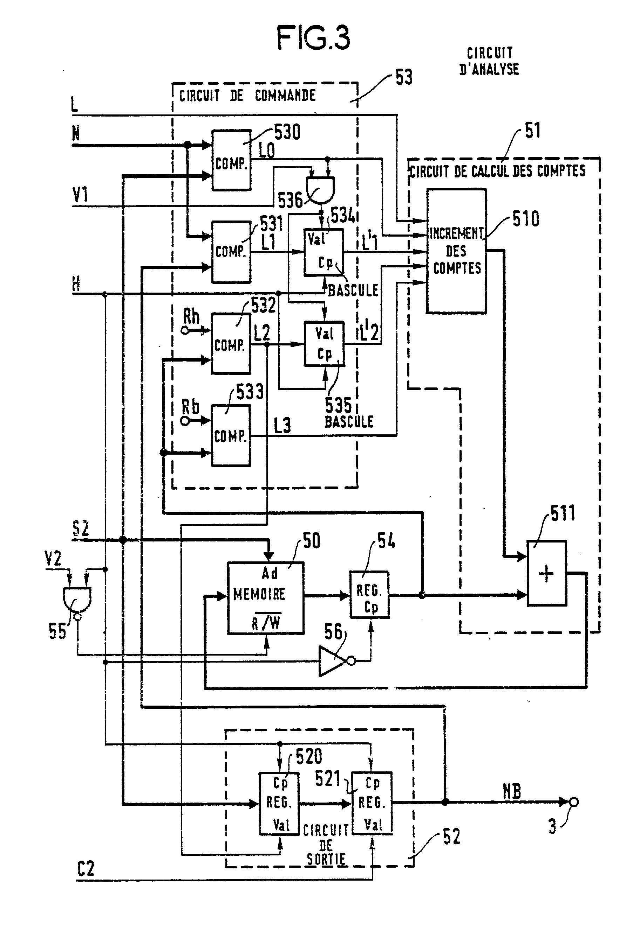

Dans la figure 3 on a détaillé le circuit 5 d'analyse des valeurs sélectionnées N qu'il reçoit du circuit 4 de la figure 1.

Ce circuit 5 d'analyse comporte essentiellement une mémoire adressable 50 dans laquelle sont mémorisés les comptes relatifs aux valeurs $N_0$ à $N_{15}$ respectivement, un circuit 51 de calcul de chacun de ces comptes, un circuit de sortie 52 fournissant sur une sortie, qui constitue la sortie 3 du dispositif, la valeur définie numériquement du niveau de bruit évalué NB, et un circuit de commande 53 commandant le circuit 51 de calcul des comptes et le circuit de sortie 52.

La mémoire 50 a une entrée « données » connectée à la sortie du circuit 51 de calcul des comptes respectifs. Elle a une entrée de commande de lecture et d'écriture $\overline{R/W}$ connectée à la sortie d'une porte logique « non et » 55 qui reçoit d'une part le signal d'horloge H et d'autre part le signal $V_2$ ; par le niveau « 1 » sur sa sortie cette porte 55 commande la lecture de la mémoire 50 alors que par le niveau « 0 » sur sa sortie elle commande la préparation d'une opération d'écriture dans la mémoire, opération qui sera effectuée sur la première transition suivante de ce niveau « 0 » au niveau « 1 ». La mémoire 50 a également une entrée de commande d'adressage Ad sur laquelle est appliqué le signal de séquence $S_2$ définissant les séquences $s_2$ chacune s'écoulant sur 16 périodes du signal H et constituée d'une suite de nombres de 0 à 15 c'est-à-dire de la suite des codes affectés aux valeurs $N_0$ à $N_{15}$ défilant à la cadence d'échantillonnage, sur chaque intervalle I la première séquence $s_2$ qui s'y déroule démarrant avec la deuxième période d'échantillonnage. Le signal $V_2$ est au niveau « 1 » pendant le déroulement de la deuxième séquence $s_2$ sur chaque intervalle I et au niveau « 0 » le reste du temps. Les opérations d'écriture dans la mémoire 50, correspondant à la mise à jour des comptes, s'effectuent ainsi pour chaque intervalle I au cours du déroulement de la deuxième séquence $s_2$ ; pendant le reste du temps, la mémoire 50 reste constamment en lecture.

Le circuit de commande 53 est connecté aux sorties du circuit 4 (figure 1 ou 2) pour recevoir le signal logique L et les valeurs sélectionnées N et à la sortie du circuit 52 (ou à la sortie du dispositif) pour recevoir la valeur du niveau de bruit évalué NB. Il est connecté aussi à la sortie de la mémoire 50 à travers un registre 54 piloté par le signal d'horloge H inversé dans une porte logique inverseuse 56, pour recevoir les comptes mémorisés. Il reçoit, en outre, le signal d'horloge H, le signal de séquence $S_2$ et le signal $V_1$ au niveau « 1 » pendant le déroulement de la première séquence $s_2$ sur chaque intervalle I et au niveau « 0 » pendant le reste du temps.

Ce circuit de commande 53 comporte essentiellement quatre comparateurs 530 à 533 et deux bascules de type D 534 et 535.

Les comparateurs 530 et 531 reçoivent chacun sur une première entrée connectée à la seconde sortie du circuit 4 (figures 1 et 2) les valeurs sélectionnées N et sur une seconde entrée le signal de séquence $S_2$, en ce qui concerne le comparateur 530, et le code de la valeur de niveau de bruit NB, en ce qui concerne le comparateur 531. Chacun de ces deux comparateurs délivre un signal logique $L_0$ ou $L_1$, selon le comparateur 530 ou 531 considéré, au niveau « 1 » ou « 0 » selon que les codes reçus sur ses deux entrées sont égaux ou pas. Les comparateurs 532 et 533 sont des comparateurs à seuil qui reçoivent chacun du registre 54 les comptes mémorisés dans la mémoire 50 et les comparent l'un, soit le comparateur 532, avec le seuil haut fixé pour tous les comptes et l'autre 533, avec le seuil bas fixé pour tous les comptes. Ces seuils haut et bas mentionnés ci-avant au cours de la description de la figure 1 sont désignés par $R_h$ et $R_b$ ; ils sont choisis proches respectivement des limites supérieure et inférieure entre lesquelles on choisit de maintenir l'évolution des comptes et leur introduction a pour but de permettre le maintien des comptes entre ces limites. Chacun de ces deux derniers comparateurs 532 et 533 délivre un signal logique $L_2$ ou $L_3$, selon le comparateur considéré, au niveau « 1 » ou « 0 » selon que le compte mémorisé reçu dépasse ou non son seuil.

Les deux bascules de type D 534 et 535 ont leurs entrées « D » connectées aux sorties des comparateurs 531 et 532 respectivement. Elles sont cadencées par le signal d'horloge H validé par le signal de sortie d'une porte logique « et » 536 du circuit 53; le signal de sortie de cette porte « et » étant appliqué à chacune de ces deux bascules sur une entrée de validation d'horloge Val et le signal d'horloge H sur leur entrée horloge Cp. La porte 536 a une entrée connectée à la sortie du comparateur 530 et reçoit sur une autre entrée le signal $V_1$ ; son signal de sortie valide ainsi le signal d'horloge H au cours du déroulement de la première séquence $s_2$ de chaque intervalle I lorsque la mémoire 50 délivre le compte concernant celles des valeurs $N_0$ à $N_{15}$ dont le code est délivré par le circuit 4 (figures 1 et 2) et appliqué sur les premières entrées des comparateurs 530 et 531.

Les signaux de sortie $L_0$ et $L_3$ des comparateurs 530 et 533 et ceux $L'_1$ et $L'_2$ des bascules 534 et 535 ainsi que le signal logique L fourni par le circuit 4 et que délivre inchangé le circuit de commande 53 sont appliqués au circuit 51 de calcul des comptes. Ce circuit de calcul 51 est composé d'un circuit de définition d'incrément de compte 510 recevant les cinq signaux L, $L_0$, $L'_1$, $L'_2$ et $L_3$ et d'un circuit sommateur 511 relié à la sortie du circuit 510. Ce circuit 510 de définition d'incrément de compte délivre en réponse à ses cinq signaux d'entrée, une valeur d'incrément positive, négative ou nulle, définie selon une loi déterminée. C'est cette valeur d'incrément qui est appliquée au circuit sommateur 511 sur l'une de ses entrées. L'autre entrée de ce circuit sommateur 511 est connectée à travers le registre 54 à la sortie de la mémoire 50, tandis que sa sortie qui constitue celle du circuit de calcul 51 est connectée à l'entrée de la mémoire 50.

Le circuit de sortie 52 est composé de deux registres 520 et 521. Le registre 520 reçoit en entrée le signal de séquence $S_2$ en vue de mémoriser le code défini par ce signal $S_2$ lorsque le compte concernant celle des valeurs $N_0$ à $N_{15}$ ainsi codée dépasse ledit seuil haut. Le registre 521 est disposé à la suite du registre 520. Ces deux registres 520 et 521 sont tous deux cadencés par le signal d'horloge H appliqué à leur entrée horloge $C_p$. Ce signal d'horloge H est validé, en ce qui concerne le registre 520, par le signal $L_2$ de sortie du comparateur 532 appliqué sur son entrée de validation d'horloge Val et, en ce qui concerne le registre 521, par le signal $C_2$ appliqué sur son entrée de validation d'horloge Val. Ce signal $C_2$ est sur chaque intervalle I, au niveau « 1 » pendant la période d'échantillonnage où démarre la deuxième séquence $s_2$, c'est-à-dire la dix-huitième période d'échantillonnage sur cet intervalle, et au niveau « 0 » autrement. Le code présent dans le registre 520 à la fin de cette dix-huitième période d'échantillonnage est alors transféré au registre 521 qui l'applique à la sortie 3 du dispositif.

Le tableau II, donné ci-après, indique les différentes valeurs d'incrément de compte définies par le circuit 510 en réponse aux signaux logiques qu'il reçoit. Les valeurs non nulles d'incrément qui y sont précisées, à titre d'exemple, correspondent à un plafond de l'ordre de 255 pour les comptes exprimés sur huit bits.

Tableau II

| L'$_2$ L'$_1$ | L | o | 1 | 1 | 1 |
| | L$_0$ | o ou 1 | 0 | 0 | 1 |
| | L$_3$ | o ou 1 | 0 | 1 | o ou 1 |
| 0 0 | | 0 | 0 | 0 | 4 |
| 1 0 | | 0 | 0 | −4 | 0 |
| 0 1 | | 0 | 0 | 0 | 5 |
| 1 1 | | 0 | 0 | −5 | 0 |

Le circuit de définition d'incrément de compte 510 est constitué, par exemple, d'une mémoire de type PROM délivrant les valeurs d'incrément exprimées sur huit bits en utilisant les compléments à $2^8$ pour les valeurs négatives. Le circuit sommateur 511 est alors constitué d'un simple additionneur à deux entrées à huit bits et une sortie à huit bits. Les seuils $R_h$ et $R_b$ des comparateurs 532 et 533 sont choisis par exemple égaux à 247 et 7 respectivement, et ces deux comparateurs sont alors un simple circuit logique « et » à 5 entrées et un simple circuit logique « ou » à 5 entrées, respectivement, recevant chacun les seuls cinq bits de plus forts poids des comptes mémorisés.

En fonctionnement, par le signal $V_2$ appliqué à la porte « non et » 55, la mémoire 50 est alternativement en écriture et en lecture pendant la seule deuxième séquence $s_2$, qui se déroule à la cadence d'échantillonnage, de chaque intervalle I ; elle est uniquement en lecture pendant les autres séquences $s_2$, qui se déroulent également à la cadence d'échantillonnage, de chaque intervalle I.

Par ailleurs, pendant la première séquence $s_2$ de chaque intervalle I, lorsqu'au début d'une période du signal H apparaît dans cette première séquence le même code que celui de la valeur fournie par le circuit 4 (figures 1 et 2), le signal $L_0$ de sortie du comparateur 530 passe au niveau « 1 ». Par le signal $V_1$ au niveau « 1 » pendant le déroulement de cette première séquence $s_2$, le signal de sortie de la porte « et » 536 valide alors le signal d'horloge H appliqué aux bascules 534 et 535. Ces deux bascules, dans ces conditions, échantillonnent les signaux de sortie $L_1$ et $L_2$ des comparateurs 531 et 532 respectivement à la fin de la période du signal d'horloge H concernée, juste avant que le signal de sortie de cette porte 536 ne repasse au niveau « 0 » au début de la période suivante du signal d'horloge. On emmagasine ainsi dans la bascule 534, une information indiquant si la valeur fournie par le circuit 4 est égale ou non à la valeur de bruit évalué NB actuelle, cette valeur de bruit évalué ne subissant pas de modification au cours du déroulement de cette première séquence $s_2$ pendant laquelle le signal $C_2$ au niveau « 0 ». On

9

emmagasine aussi, dans la bascule 535, une information indiquant si le compte concernant celle des valeurs $N_0$ à $N_{15}$ à laquelle correspond la valeur codée fournie par le circuit 4 dépasse ou non le seuil haut $R_h$.

Par ailleurs, lorsque l'un des comptes délivrés par la mémoire 50 est supérieur au seuil haut $R_h$ du comparateur 532, le signal $L_2$ de sortie de ce comparateur passe au niveau « 1 » et valide le signal d'horloge H appliqué au registre 520. Ce registre 520 échantillonne alors le signal de séquence $S_2$ à la fin de la période du signal H pendant laquelle ce compte est délivré par la mémoire 50, pour emmagasiner le code de celle des valeurs $N_0$ à $N_{15}$ concernée. Après le déroulement de cette première séquence $s_2$ le registre 520 contient donc soit ce qui est le cas le plus général, le code de l'unique valeur parmi les valeurs $N_0$ à $N_{15}$ pour lequel le compte dépasse le seuil haut $R_h$, soit, le cas échéant, le code de la plus grande de celles des valeurs $N_0$ à $N_{15}$ dont les comptes dépassent le seuil haut sauf éventuellement en ce qui concerne les intervalles de temps I d'une période de mise en route du dispositif, c'est-à-dire faisant suite à la mise sous tension du dispositif, où ce registre pourra contenir le code d'une valeur particulière qu'une commande d'initialisation, non représentée, y aura inscrit cette même commande assurant en outre la mise à zéro de la mémoire 50.

Pendant la deuxième séquence $s_2$ qui se déroule sur chaque intervalle de temps I, la mémoire 50 est alternativement en lecture et en écriture au rythme des transitions de niveau du signal d'horloge H. Elle délivre successivement les comptes mémorisés relatifs aux valeurs $N_0$ à $N_{15}$ respectivement, chacun pendant la première moitié d'une période du signal d'horloge H où celui-ci est alors au niveau « 1 ». A la fin de la première moitié de chaque période de ce signal d'horloge H, le compte délivré par le mémoire 50 est échantillonné par le registre 54 qui l'applique ensuite aux comparateurs 532 et 533 du circuit de commande 53 et au sommateur 511 du circuit de calcul des comptes 51 jusqu'à la fin de la première moitié de la période suivante du signal d'horloge H. Le signal $V_1$ étant au niveau « 0 » pendant cette deuxième séquence $s_2$, les signaux de sortie $L'_1$ et $L'_2$ des bascules 534 et 535 demeurent inchangés et sont ce qu'ils étaient à la fin du déroulement de la première séquence $s_2$ du même intervalle de temps I, qui précédait juste cette deuxième séquence $s_2$ considérée. Pendant la majeure partie de la seconde moitié de chaque jième ($1 \leqslant j \leqslant 16$) période du signal d'horloge H comptée à partir du démarrage de cette seconde séquence et jusqu'à la fin de cette jième période pendant laquelle le signal de séquence $S_1$ a pour valeur celle du code $j - 1$, les signaux appliqués par le circuit de commande 53 au circuit de définition d'incrément 510 indiquent :

— par L au niveau « 1 » ou « 0 » invariable pendant toute cette séquence, si la valeur de niveau délivré par le circuit 4 (figures 1 et 2) est ou non sélectionnée,

— par $L_0$ au niveau « 1 » ou « 0 », variable au début de chaque période du signal d'horloge H, si le code $j - 1$ est ou non celui de la valeur de niveau délivrée par le circuit 4,

— par $L'_1$ au niveau « 1 » ou « 0 », si la valeur délivrée pour le circuit 4 est ou non égale à la valeur de niveau de bruit évalué NB présent en sortie du dispositif au cours de la première séquence $s_2$ du même intervalle de temps I (ce signal $L'_1$ étant défini au cours de la première séquence $s_2$ et restant inchangé pendant cette deuxième séquence $s_2$),

— par $L'_2$ au niveau « 1 » ou « 0 », si le compte concernant celle des valeurs $N_0$ à $N_{15}$ à laquelle est égale la valeur délivrée par le circuit 4 dépasse ou non le seuil haut $R_h$ (ce signal étant défini au cours de la première séquence $s_2$ du même intervalle de temps I),

— par $L_3$ au niveau « 1 » ou « 0 », variable au début de la seconde moitié de chaque période du signal d'horloge H, si le compte concernant la valeur $N_{j-1}$ dépasse ou non le seuil bas $R_b$.

Le circuit de définition d'incrément de compte 510 délivre en réponse à ces signaux la valeur d'incrément de compte correspondante, selon le tableau II précédent.

Le compte actualisé concernant la valeur $N_{j-1}$ est alors disponible en sortie du sommateur 511 et est inscrit dans la mémoire 50 lors de l'opération d'écriture qui s'effectue sur le front montant du signal d'horloge H marquant la fin de cette jième période. Ainsi, en présence d'une valeur sélectionnée N en sortie du circuit 4 sur l'intervalle I considéré, si le compte concerné par cette valeur sélectionnée N, — c'est-à-dire le compte relatif à la valeur discrète à laquelle est égale cette valeur sélectionnée N, ne dépasse pas le seuil haut — $R_h$ ($R_h = 247$), ce compte est augmenté de quatre unités, ou éventuellement de cinq unités si cette valeur N est égale à la valeur présente sur la sortie 3 du dispositif pendant la première séquence $s_2$ de l'intervalle I considéré ce qui en pratique ne peut se produire qu'au cours d'une période de mise en route du dispositif, tandis qu'aucun des autres comptes n'est modifié. Par contre, si le compte concerné par cette valeur sélectionnée N dépasse le seuil haut $R_h$, ce compte reste inchangé tandis que ceux des autres comptes supérieurs au seuil bas $R_b$ ($R_b = 7$) sont diminués de quatre ou cinq unités selon que cette valeur sélectionnée N n'est pas ou est égale à la valeur présente en sortie 3 du dispositif pendant la première séquence $s_2$ de l'intervalle I considéré, ceux des comptes ne dépassant pas ce seuil bas $R_b$ n'étant pas modifié. En l'absence de valeur sélectionnée N en sortie du circuit 4 sur l'intervalle I considéré, aucun des comptes n'est modifié.

Le code emmagasiné par le registre 520 à la suite du déroulement de la première séquence $s_2$ étant échantillonné par le registre 521 à la fin de la première période d'horloge de la seconde séquence $s_2$, le signal $C_2$ de validation d'horloge étant au niveau 1, c'est ce code délivré en sortie du dispositif qui définit la nouvelle valeur de niveau de bruit évalué NB.

Dans ce fonctionnement, en regard de la valeur absolue d'incrément de compte de 5 ou 4, on notera que la pondération plus ou moins forte d'une valeur sélectionnée N selon qu'elle est ou non égale à la valeur courante du niveau de bruit évalué NB procure une hytérésis évitant d'éventuels battements.

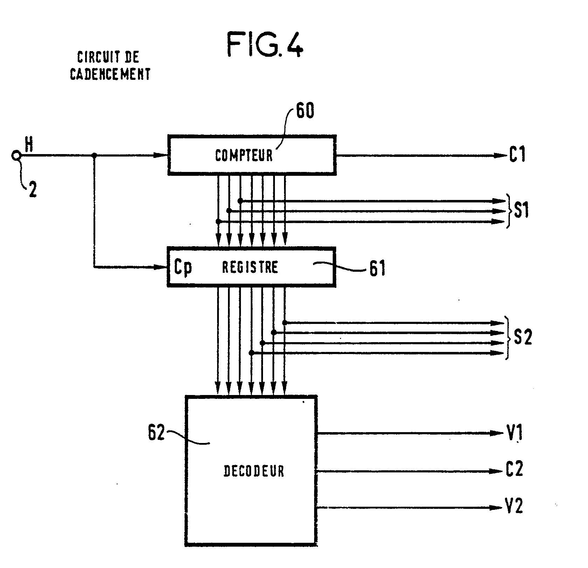

Dans la figure 4, on a détaillé le circuit de cadencement 6 de la figure 1 élaborant à partir du signal d'horloge H qu'il reçoit les différents signaux $C_1$ et $S_1$ appliqués au circuit 4 d'évaluation et de sélection des valeurs du niveau du signal présent sur la voie et $C_2$, $V_1$, $V_2$ et $S_2$ appliqués au circuit 5 d'analyse des valeurs sélectionnées.

Le circuit de cadencement 6 est décrit dans le cadre de l'exemple chiffré considéré ci-avant, en particulier en regard des figures 2 et 3. Il comprend un compteur 60 recevant en entrée le signal d'horloge H appliqué à l'entrée 2 du dispositif, un registre 61 recevant les états successifs du compteur 60 qu'il retarde d'une période du signal d'horloge H et un décodeur 62 recevant les états successifs du compteur 60 avec le retard introduit par le registre 61.

Le compteur 60 est un compteur par 128. Il délivre en sortie les états 0 à 127 définis sur sept bits, à la cadence d'échantillonnage en une durée égale à chaque intervalle de temps I, soit 16 ms. Il élabore le signal de cadencement $C_1$ prenant le niveau « 1 » pour son état 0 de sortie et le niveau « 0 » pour tout autre état, qui définit les intervalles de temps successifs I. Ce signal $C_1$ qui est illustré délivré sur une sortie indépendante du compteur peut être obtenu sur la sortie d'une porte logique « non-ou » recevant en entrée les états successifs pris par le compteur. Il élabore également le signal de séquence $S_1$ qui définit la séquence $s_1$ sur chaque intervalle de temps I, divisant chaque intervalle de temps I en huit sous-intervalles égaux pour l'évolution de la valeur absolue du pas de variation p de la valeur de comparaison n. Ce signal de séquence $S_1$ est défini par les trois bits de poids forts des états successifs du compteur et chaque séquence $s_1$ est donc constituée d'une suite de huit nombres, de 0 à 7, défilant régulièrement sur l'intervalle de temps I considéré.

Le registre 61 reçoit les sept bits définissant les états successifs pris par le compteur et le signal d'horloge H sur son entrée horloge $C_p$ pour élaborer en sortie le signal de séquence $S_2$ qui définit les séquences $s_2$ dans la durée de chaque intervalle I. Ce signal de séquence $S_2$ est défini par les quatre bits de poids faibles des états du compteur délivrés avec le retard d'une période du signal d'horloge à la sortie du registre. Il définit donc huit séquences $s_2$ sur chaque intervalle I, la première séquence démarrant avec le retard indiqué soit sur la deuxième période d'échantillonnage de l'intervalle de temps I considéré, constituées chacune par la suite des nombres 0 à 15 défilant à la cadence d'échantillonnage.

Le décodeur 62 reçoit les sept bits définissant les états successifs du compteur avec le retard introduit par le registre 61. Il est agencé pour délivrer le signal $V_1$ au niveau « 1 » pour les états 0 à 15 du compteur 60 qu'il reçoit du registre 61 et au niveau « 0 » pour les autres états et le signal $V_2$ au niveau « 1 » pour les états 16 à 31 qu'il reçoit et au niveau « 0 » pour les autres états. Ces deux signaux $V_1$ et $V_2$ sélectionnent donc respectivement la première et la deuxième des séquences $s_2$ contenues dans le signal de séquence $S_2$ précité. Ce décodeur 62 est en outre agencé pour délivrer le signal de cadencement $C_2$ au niveau « 1 » pour l'état 16 du compteur 60 qu'il reçoit du registre 61 et au niveau « 0 » pour tous les autres états qu'il reçoit, c'est-à-dire de même durée que le signal $C_1$ mais démarrant avec la deuxième séquence $s_2$ c'est-à-dire décalé du signal $C_1$ de dix-sept périodes du signal d'horloge. Ce décodeur 62 peut être également constitué à l'aide d'une mémoire PROM.

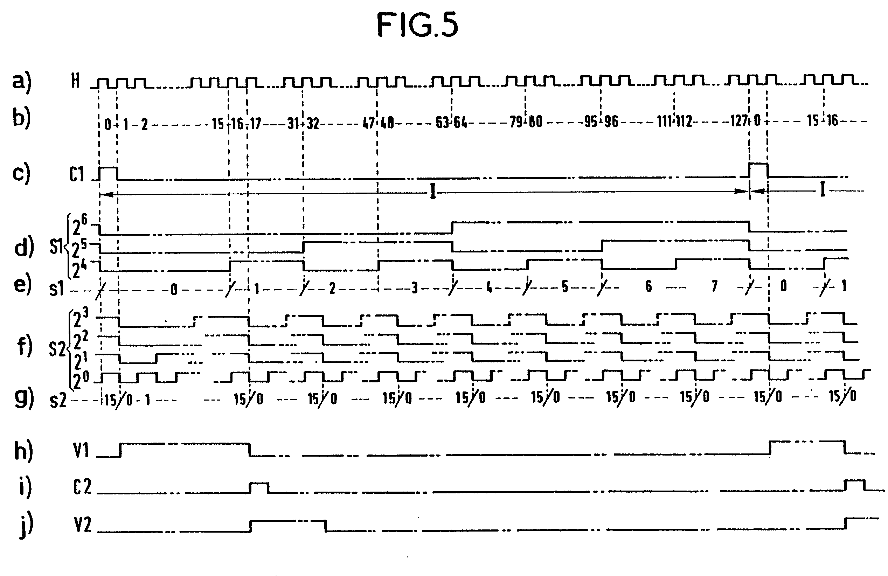

Dans la figure 5, on a illustré les divers signaux délivrés par le circuit de cadencement donné dans la figure 4 et appliqués au dispositif ainsi qu'expliqué ci-avant en regard des figures 1 à 4. Dans cette figure 5 :

— le diagramme a) illustre le signal d'horloge H définissant la cadence d'échantillonnage du signal présent sur la voie,

— le diagramme b) donne dans la numérotation décimale les états successifs pris par le compteur 60, ces états évoluant de manière cyclique de 0 à 127, à la cadence du signal H,

— le diagramme c) illustre le signal de cadencement $C_1$ obtenu à partir du compteur 60, ce signal $C_1$ étant au niveau « 1 » uniquement pour l'état 0 du compteur, qui définit les intervalles de temps successifs I au cours de chacun desquels sera évalué le niveau du signal présent sur la voie,

— le diagramme d) illustre le signal de séquence $S_1$ défini par les trois bits de plus forts poids notés $2^4$, $2^5$ et $2^6$ des états successifs du compteur 60, et on a fait apparaître dans le diagramme e) la séquence $s_1$ qui se déroule dans chaque intervalle I en prenant les valeurs, notées en numérotation décimale 0 à 7, définies par les trois bits du signal $S_1$, et qui divise ainsi l'intervalle considéré en huit sous-intervalles pour le fonctionnement du circuit 4 d'évaluation et de sélection des valeurs du niveau du signal présent sur la voie (figures 1 et 2),

— le diagramme f) illustre le signal de séquence $S_2$ défini par les quatre bits de plus faibles poids notés $2^0$ à $2^3$ des états successifs du compteur qui sont transmis avec un retard d'une période du signal d'horloge H, et on a fait apparaître dans le diagramme g) les séquences répétitives $s_2$, au nombre de huit qui se déroulent avec un décalage d'une période du signal H dans la durée d'un intervalle de temps I, en prenant à la cadence du signal d'horloge H les valeurs 0 à 15 de la numérotation décimale, définies par les quatre bits du signal $S_2$,

— le diagramme h) illustre le signal $V_1$ de sélection de la première séquence $s_2$ de chaque intervalle I, le diagramme i) illustre le signal de cadencement $C_2$ au niveau « 1 » pour l'état 16 du compteur 60 transmis avec le retard d'une période du signal d'horloge H et le diagramme j) le signal $V_2$ de sélection de la deuxième séquence $s_2$ de chaque intervalle de temps I, ces signaux $V_1$, $V_2$ et $C_2$ commandant le circuit

11

de calcul de la valeur du niveau de bruit NB auquel ils sont appliqués.

En complément de la description ci-avant, on précise, en outre, que le bruit présent pendant les brèves pauses intersyllabiques, dont la durée de chacune est de l'ordre de 50 ms et qui représentent globalement 20 % environ du temps d'un discours continu, contribue à l'évaluation du niveau de bruit. Ceci procure un temps d'acquisition court, variable de 1 à 4 ou 5 secondes dans l'exemple chiffré décrit ci-avant, même lorsque la voie traitée achemine, en plus des signaux de parole utiles, des signaux d'écho.

En regard du mode de réalisation décrit ci-avant, il est possible sans sortir du cadre de l'invention de modifier certaines dispositions ou remplacer certains moyens par des moyens équivalents.

Notamment, il est bien entendu que l'évaluation du niveau du signal présent sur la voie téléphonique pourrait se faire, en ce qui concerne la plage de niveau de bruit (P), directement à l'aide des valeurs discrètes ($N_0$ à $N_{r-1}$) que l'on définit dans cette plage pour l'évaluation du niveau de bruit, l'opération de transcodage qu'effectue le circuit de sélection (41) dans l'exemple de réalisation décrit n'étant pas alors utile. Par ailleurs, il est bien évident que l'on pourrait faire appel à des circuits analogiques pour l'évaluation du niveau du signal présent sur la voie téléphonique en particulier, ce signal étant par exemple disponible sur la voie sous forme analogique.

## Revendications

1. Procédé d'évaluation du niveau de bruit sur une voie téléphonique selon lequel on évalue le niveau du signal présent sur la voie sur des intervalles de temps successifs I sensiblement de même durée, caractérisé par le fait qu'il consiste, en outre, à :
— attribuer au niveau de bruit sur cette voie une plage donnée de valeurs possibles, définie à partir d'une valeur de niveau maximal de bruit admis sur la voie et dite plage de niveau de bruit (P) dans laquelle s'étend un ensemble défini limité de valeurs discrètes,
— sélectionner les valeurs successives de niveau de signal présent sur la voie, sur lesdits intervalles de temps et tombant dans ladite plage de niveau de bruit (P),
— tenir une comptabilité relative des valeurs sélectionnées exprimées à l'aide desdites valeurs discrètes et prendre pour valeur du niveau de bruit celle des valeurs discrètes sur laquelle se concentre la majorité des valeurs sélectionnées.

2. Procédé d'évaluation du niveau de bruit selon la revendication 1, selon lequel on évalue le niveau de signal présent sur la voie téléphonique à partir de la comparaison de l'amplitude des échantillons successifs du signal présent sur la voie échantillonné à cadence régulière avec une valeur de niveau de comparaison, caractérisé en ce qu'il consiste, en outre, pour l'évaluation du niveau du signal présent sur la voie téléphonique, à :
— découper chaque intervalle de temps I en sous-intervalles de temps définis,
— élaborer, pendant chaque intervalle de temps I, la valeur dudit niveau de comparaison (n) par cumul à la cadence d'échantillonnage de pas de variation (p) de la valeur de niveau de comparaison, dont le signe est défini en réponse à la comparaison alors effectuée et dont la valeur absolue est fonction du sous-intervalle de temps alors concerné de l'intervalle de temps I considéré,
— et prendre, comme valeur de niveau de signal présent sur la voie, la valeur de niveau de comparaison (n) à la fin de chaque intervalle de temps I.

3. Procédé d'évaluation du niveau de bruit selon la revendication 2, caractérisé par le fait que la valeur absolue du pas (p) sur chaque intervalle de temps I répond à une loi d'évolution décroissante prédéterminée.

4. Procédé d'évaluation du niveau de bruit selon la revendication 2, caractérisé par le fait que la valeur absolue du pas (p) sur chaque intervalle est en outre fonction de la valeur absolue de la différence entre l'amplitude de l'échantillon et la valeur de niveau comparées l'une à l'autre.

5. Procédé d'évaluation du niveau de bruit selon la revendication 4, caractérisé par le fait que la valeur absolue du pas (p) est définie sur chaque intervalle de temps I par la valeur absolue de la différence entre l'amplitude de l'échantillon et la valeur de niveau comparées l'une à l'autre, affectée d'un coefficient de proportionnalité allant décroissant au fur et à mesure que se déroule l'intervalle de temps considéré.

6. Procédé d'évaluation du niveau de bruit selon l'une des revendications 2 à 5, caractérisé par le fait que ledit cumul des pas de variation de la valeur du niveau de comparaison est limité entre une valeur inférieure et une valeur supérieure déterminées définissant une plage de niveau incluant ladite plage de niveau de bruit (P) en la débordant au moins supérieurement.

7. Procédé d'évaluation du niveau de bruit selon l'une des revendications 1 à 6, caractérisé par le fait que la comptabilité relative des valeurs sélectionnées exprimées à l'aide desdites valeurs discrètes est effectuée en tenant pour chacune desdites valeurs un compte qui est modifié d'un incrément
— de valeur positive chaque fois qu'une valeur sélectionnée est égale à la valeur discrète considérée alors que ce compte relatif à la valeur discrète considérée ne dépasse pas un seuil haut de compte préétabli ($R_h$) et
— de valeur négative chaque fois qu'une valeur sélectionnée est égale à une valeur discrète différente de la valeur discrète considérée alors que le compte relatif à cette valeur discrète différente dépasse ledit seuil haut ($R_h$) tandis que ce compte relatif à la valeur discrète considérée est supérieur à un seuil bas de compte préétabli (R$_b$).

8. Procédé d'évaluation du niveau de bruit selon l'une des revendications 1 à 7, caractérisé en ce que, dans la comptabilité relative des valeurs sélectionnées, chaque valeur sélectionnée est pondérée plus ou moins fortement selon qu'elle est égale ou non à la valeur courante du niveau de bruit évalué.

9. Dispositif pour la mise en œuvre du procédé d'évaluation du niveau de bruit selon la revendication 1, comportant un circuit (40) d'évaluation du niveau du signal présent sur la voie téléphonique sur des intervalles de temps successifs I sensiblement de même durée, caractérisé en ce qu'il comporte, en outre

— un circuit de sélection (41) sélectionnant, parmi les valeurs de niveau de signal présent sur la voie qu'il reçoit du circuit d'évaluation (40), les seules valeurs (N) comprises dans ladite plage de niveau de bruit (P) et les délivrant exprimées à l'aide d'un ensemble limité défini de r valeurs discrètes (N$_0$ à N$_{r-1}$),

— un circuit (5) d'analyse des valeurs sélectionnées délivrées par le circuit de sélection (41), sensible à la répartition desdites valeurs sélectionnées (N) entre lesdites r valeurs discrètes (N$_0$ à N$_{r-1}$), repérant celle des valeurs discrètes sur laquelle se concentre la majorité des valeurs sélectionnées pour la délivrer sur une sortie (3) en tant que valeur représentative du niveau de bruit (NB),

— et un circuit de cadencement (6) des circuits d'évaluation (40) et de sélection (41) de niveau de signal présent sur la voie, ainsi que du circuit d'analyse pour la détermination de la valeur du niveau de bruit au rythme desdits intervalles de temps I définis par ce circuit de cadencement.

10. Dispositif selon la revendication 9, dans lequel ledit circuit d'évaluation (40) du niveau du signal présent sur la voie comporte un comparateur (400) comparant l'amplitude des échantillons du signal présent sur la voie échantillonné à cadence régulière avec une valeur de niveau de comparaison (n), caractérisé en ce que ledit circuit d'évaluation de niveau (40) est constitué d'une boucle d'asservissement qui comporte :

— ledit comparateur (400) délivrant un signal logique indiquant par son niveau si l'amplitude de l'échantillon comparé à la valeur de niveau de comparaison (n) lui est supérieure ou non,

— un circuit (401) de définition de variation du niveau de comparaison (n) recevant le signal logique de comparaison ainsi qu'un signal de séquence (S$_1$), dit premier signal de séquence, élaboré par ledit circuit de cadencement (6) et définissant une suite de séquences identiques (s$_1$) se déroulant respectivement sur les intervalles de temps I successifs, pour délivrer un pas de variation (p) de signe défini par ledit signal logique et de valeur absolue variable sous le contrôle dudit premier signal de séquence (S$_1$)

— et un accumulateur (402) connecté à la sortie du circuit (401) de définition de variation du niveau de comparaison (n) et fonctionnant à la cadence d'échantillonnage du signal présent sur la voie pour délivrer la valeur dudit niveau de comparaison (n) qui définit à la fin de chaque intervalle de temps I la valeur du niveau du signal présent sur la voie.

11. Dispositif selon la revendication 10, caractérisé par le fait que ledit accumulateur (402) présente une butée inférieure et une butée supérieure définissant pour le niveau de comparaison (n) une plage de variation incluant ladite plage de niveau de bruit (P) en la débordant au moins supérieurement.

12. Dispositif selon l'une des revendications 9 à 11, caractérisé par le fait que ledit circuit d'analyse (5) des valeurs sélectionnées comporte :

— une mémoire (50) adressable adressée sous le contrôle d'un signal de séquence (S$_2$), dit deuxième signal de séquence, élaboré par ledit circuit de cadencement (6), mémorisant pour les r valeurs discrètes (N$_0$ à N$_{r-1}$) r comptes respectivement traduisant la répartition des valeurs sélectionnées (N) délivrées par le circuit de sélection (41) entre les r valeurs discrètes (N$_0$ à N$_{r-1}$),

— un circuit de calcul des comptes (51) comportant d'une part un circuit (510) de définition d'incrément de compte et d'autre part un circuit sommateur (511) ayant deux entrées reliées à la sortie de la mémoire (50) et à la sortie dudit circuit (510) de définition d'incrément de compte respectivement et une sortie reliée à l'entrée de ladite mémoire,

— un circuit de commande (53) comportant des circuits comparateurs (530, 532, 533) comparant, pour chaque valeur sélectionnée (N) délivrée par le circuit de sélection (41), d'une part les différentes valeurs discrètes (N$_0$ à N$_{r-1}$) reçues en concordance avec l'adressage de ladite mémoire (50) avec la valeur sélectionnée considérée pour identifier le compte mémorisé concerné par cette valeur sélectionnée et d'autre part les différents comptes mémorisés avec un seuil haut et un seuil bas de compte (R$_h$, R$_b$) préétablis, commandant, dans ledit circuit de définition d'incrément de compte, pour chaque valeur sélectionnée (N) délivrée par le circuit de sélection (41), le choix d'une valeur d'incrément positive pour le seul compte concerné par la valeur sélectionnée considérée si celui-ci ne dépasse pas ledit seuil haut (R$_h$) ou d'une valeur d'incrément négative pour les autres comptes supérieurs audit seuil bas (R$_b$) si ce compte concerné par la valeur sélectionnée considérée dépasse ledit seuil haut (R$_h$),

— et un circuit de sortie (52) de la valeur de niveau de bruit commandé par ledit circuit de commande (53) lors de la détection du dépassement dudit seuil haut (R$_h$) par l'un des comptes mémorisés, recevant la valeur discrète concernée par ce compte dépassant ledit seuil haut.

13. Dispositif selon la revendication 12, caractérisé par le fait que ledit deuxième signal de séquence (S$_2$) élaboré par ledit circuit de cadencement (6) définit sur la durée de chaque intervalle de temps I au moins deux séquences (s$_2$) dont le déroulement de chacune est représentatif desdites r valeurs discrètes, ces séquences (s$_2$) définies par ledit deuxième signal de séquence (S$_2$) étant mises à profit sur chaque intervalle de temps I où le circuit de sélection (41) délivre une valeur sélectionnée (N), en ce qui concerne une première de ces séquences, pour déterminer dans ledit circuit de commande (53) la position. du compte concerné par cette valeur sélectionnée par rapport audit seuil haut ($R_h$) et, en ce qui concerne une seconde de ces séquences, postérieure à ladite première, pour mettre à jour les comptes dans la mémoire en fonction du résultat de la détermination effectuée au cours de ladite première séquence et, le cas échéant, des positions des autres comptes par rapport audit seuil bas ($R_b$) déterminées au cours de cette seconde séquence pour chacun des comptes non encore mis à jour.

14. Dispositif selon la revendication 12, caractérisé en ce que ledit circuit de commande (53) est relié à la sortie du dispositif et comporte en outre un comparateur (531) comparant chaque valeur sélectionnée (N) délivrée par le circuit de sélection (41) avec la valeur du niveau de bruit (NB) alors délivrée en sortie du dispositif pour commander, dans ledit circuit de définition d'incrément de compte, le choix d'un incrément de compte de valeur absolue plus ou moins grande selon la valeur sélectionnée considérée et égale ou non à la valeur courante du niveau de bruit évalué.

15. Dispositif selon la revendication 14, caractérisé en ce que ledit deuxième signal de séquence ($S_2$) élaboré par ledit circuit de cadencement (6) définit sur la durée de chaque intervalle de temps I au moins deux séquences ($s_2$) dont le déroulement de chacune est représentatif desdites r valeurs discrètes, ces séquences ($s_2$) définies par ledit deuxième signal de séquence ($S_2$) étant mise à profit, sur chaque intervalle de temps I où le circuit de sélection (41) délivre une valeur sélectionnée (N), en ce qui concerne une première de ces séquences, pour déterminer dans ledit circuit de commande (53) la position du compte concerné par cette valeur sélectionnée par rapport audit seuil haut ($R_h$) et déterminer dans ledit circuit de commande (53) si cette valeur sélectionnée est égale ou non à la valeur du niveau de bruit (NB) délivrée en sortie du dispositif, et, en ce qui concerne une seconde de ces séquences, postérieure à ladite première, pour mettre à jour les comptes dans la mémoire en fonction des résultats des déterminations effectuées au cours de ladite première séquence et, le cas échéant, des positions des autres comptes par rapport audit seuil bas ($R_b$) déterminées au cours de cette seconde séquence pour chacun des comptes non encore mis à jour.

**Claims**

1. A method of evaluating the noise level on a telephone channel on the basis of the level of the signal present on the channel during successive time intervals I of substantially equal duration, characterized by the fact that, the method consists of the following steps :
— assigning the noise level on said channel to a range of possible values, partly defined by a maximum noise level value admitted on the channel, referred to as noise level range (P), covering a limited defined set of discrete values ;
— selecting successive signal level values present on the channel during the said time intervals and which lie in the said noise level range (P), and
— keeping records of the different selected values expressed in terms of said discrete values to take as being representative of the noise level on the channel that one of the discrete values on which the majority of the selected noise level values are concentrated.

2. A method of evaluating the noise level according to claim 1, wherein the level of the signal present on the telephone channel is evaluated by comparing the amplitude of successive samples of the signal present on the channel which is sampled at a regular rate with a comparison level value, characterized in that it comprises, for the evaluation of the signal present on the telephone channel, the following steps :
— splitting each time interval I into defined sub-intervals ;
— generating a comparison level value (n) during each time interval I by accumulating the variation step (p) of the comparison level value at the sampling rate with the sign of the said step being defined in response to the comparison then performed and with the absolute value being a function of the current time sub-interval of the time interval under consideration ; and
— taking the comparison level value (n) at the end of each time time interval I as·the value of the signal level present on the channel.

3. A method of evaluating the noise level according to claim 2, characterized by the fact that, the absolute value (p) of the steps in each time interval I follows a predetermined decreasing law.

4. A method of evaluating the noise level according to claim 2, characterized by the fact that, the absolute value (p) of the steps at each interval is also a function of the absolute value of the difference between the amplitude of the sample and the value of the level as compared with one another.

5. A method of evaluation the noise level according to claim 4, characterized in that, the absolute value (p) of the steps is defined during each time interval I by the absolute value of the difference between the amplitude of the sample and the value of the level as compared with one another and as weighted by a proportionality coeficient which decreases throughout the duration of the time interval I under consideration.

6. A method of evaluating the noise level acc. to one of the claim 2 to 5, characterized in that, the said accumulation of variation steps in the value of the comparison level is limited between a lower stop value and an upper stop value which are fixed and define a range of levels including said range of noise levels (P), and extending beyond, at least at its upper end.

7. A method of evaluating the noise level acc. to one of the claims 1 to 6, characterized in that, the recording relating to said selected values as expressed in terms of said discrete values is performed by maintaining a count for each of said discrete values and by modifying said count by an increment :

— of positive value each time the selected value corresponds to the discrete value being processed and the count associated with said discrete value being processed is not greater than a predetermined threshold ($R_h$) ; and

— by a negative amount whenever the selected value corresponds to a discrete value other than the discrete value being processed, the count associated with the selected value exceeds said upper threshold ($R_h$), and the count associated with the discrete value being processed is greater than a predetermined lower threshold ($R_b$).

8. A method of evaluating the noise level acc. to one of the claims 1 to 7, characterized in that, when keeping the counts of the selected values, each value is weighted by a greater or lesser amount depending on whether or not it is equal to the currently evaluated noise level.

9. A device for performing the method of evaluating the noise level according to claim 1, characterized in that the device comprises : an evaluator circuit (40) for evaluating the level of the signal present on the telephone channel during successive time intervals I of substantially equal duration ;

— a selector circuit (41) connected to receive successive evaluated signal levels from the evaluator circuit (40) and for selecting only those values (N) which lie within a given level range assigned to the noise, referred to as noise level range (P), said selected values being delivered expressed in terms of a limited defined set of r discrete level values ($N_0$ to $N_{r-1}$) ;

— an analyser circuit (5) connected to receive said selected values as delivered by said selector circuit (41), said analyser circuit being sensitive to the distribution of said selected values (N) amongst said r discrete values ($N_0$ to $N_{r-1}$) for determining that one of the discrete values on which the majority of the selected values are concentrated and for delivering said determined value at an output (3) to represent the noise level (NB) ; and

— a clock circuit (6) for driving said evaluator circuit (40), said selector circuit (41), and said analyser circuit (5) to determine the noise level once every time interval I as determined by said clock circuit.

10. A device according to claim 9, wherein said evaluator circuit (40) for evaluating the signal level present on the channel comprises a comparator (400) for comparing the amplitude of single samples taken from the channel at a regular sampling rate against a comparison level (n), characterized in that the evaluator circuit (40) is constituted by a servo loop which includes :

— the said comparator (400) which delivers a logical signal indicating whether the amplitude of the sample being compared to the comparison level value (n) is greater than said value or not ;

— a circuit (401) for defining the variation in the level of the comparison value (m), said circuit receiving the logical comparison signal together with a sequence signal ($S_1$), referred to as first sequence signal, generated by the clock circuit (6) and defining a series of identical sequences ($S_1$) which take place during successive respective time intervals I, and delivering a variation step (p) of sign defined by said logical signal and of variable absolute value defined under the control of said first sequence signal ($S_1$) ; and

— an accumulator (402) connected to the output from the circuit (401) for defining the variation in the comparison level (n) and operating at the sampling frequency of the signal present on the channel to deliver the value of said comparison level (n) which defines the value of the signal level present on the channel at the end of each time interval I.

11. A device according to claim 10, characterized in that, the said accumulator (402) has a lower stop and an upper stop defining a range of variations for said comparison level (n), including said noise level range (P) and passing beyond it at least at the upper end.

12. A device according the one of the claims 1 to 11, characterized in that, the said analyser circuit (5) for analysing the selected values comprises :

— an addressable memory (50) addressed under the control of a sequence signal ($S_2$), referred to as second sequence signal, generated by said clock circuit (6), said memory storing for r discrete values ($N_0$ to $N_{r-1}$) r counts performing the distribution of the selected values (N) delivered by the selector circuit (41) from amongst the r discrete values ($N_0$ to $N_{r-1}$) ;

— a count computing circuit (51) comprising firstly a count increment defining circuit (510) for defining a count increment and secondly a two-input summing circuit (511) connected to the output of the memory (50) and to the output from said count increment defining circuit (510), and having an output connected to an input to said memory ;

— a control circuit (53) including a plurality of comparator circuits (530, 532, 533), which compares for each selected value (N) as delivered by the selector circuit (41), firstly the various discrete values ($N_0$ to $N_{r-1}$) received in concordance with the address of the said memory (50) with the selected value considered, in order to identify the memorized count concerned with that selected value, and secondly compare the various memorised counts with a predetermined upper and lower count threshold ($R_h$, $R_b$), and which controls in the said count increment defining circuit, for each selected value (N) delivered by the selector circuit (41), the choice of a positive increment value for the sole count concerned with the selected corresponding value, when the latter does not exceed the said upper threshold ($R_h$) or which controls a negative increment value for all the other counts greater than said lower threshold ($R_b$), when the count concerned with the selected value exceeds the daid upper threshold ($R_h$) ; and

— a noise level output circuit (52) controlled by said control circuit (53) when a memorised count exceeds said upper threshold value ($R_h$), receiving the discrete value concerned with the count exceeding the said upper threshold.

13. A device according to claim 12, characterized in that, the said second sequence signal ($S_2$) generated by the clock circuit (6) defines during each time interval I at least two sequences ($s_2$), each of which runs through r values representative of each of the said r discrete values, said sequences defined by the said second sequence signal ($S_2$) being used during each time interval I forwhich the selector circuit (41) deliveres a selected value (N) which determines, in the case of the first of said sequences, within the said control circuit (53) the position of the count corresponding with the selected value relative to the said upper threshold ($R_h$) ; and which updates, as to the second of said sequences, after said first of said sequences is used, the counts in the memory as a function of the comparison performed during said first sequence and, as the case may be, of the positions of the other counts relative to said lower threshold ($R_b$) as compared during said second sequence for each of the counts needing updating.

14. A device according to claim 12, characterized in that, the said control circuit (53) is connected to the output of the device and further comprisis a comparator (531) for comparing each selected value (N) as delivered by the selection circuit (41) with the value of the noise level (NB) currently being delivered at the output of the device, and wherein the choice of a count increment, whose absolute value is more or less greater depending upon the selected value, is equal to the current evaluated value of the noise level, and is smaller otherwise.

15. Device according to claim 14, characterized in that, the second sequence signal ($S_2$) generated by the clock circuit (6) defines during each time interval I at least two sequences ($s_2$), each of which runs through r values representative of each of the said r discrete values, said sequences ($s_2$) defined by said second sequence signal ($S_2$) being used during each time interval I for which the selector circuit (41) deliveres a selected value which determines, in the case of the first of said sequences within the said control circuit (53) the position of the count corresponding to the selected value relative to said upper threshold ($R_h$), and also, whether said selected value is equal or not to the noise level value (NB) delivered at the output of the device ; and which updates, as to the second of said sequences, after said first of said sequences is used, the counts in the memory as a function of the result of the determinations performed during said first sequence and, as the case may be, of the positions of the other counts relative to said lower threshold ($R_b$) as compared during said second sequence for each of the counts needing updating.

## Patentansprüche

1. Verfahren zur Beurteilung des Rauschpegels in einem Fernsprechkanal, bei dem man den Pegel des in dem Kanal befindlichen Signals während aufeinanderfolgender Zeitintervalle I von im wesentlichen gleicher Dauer beurteilt, dadurch gekennzeichnet, daß weiter

— dem Rauschpegel auf diesem Kanal ein gegebener Bereich möglicher Werte, genannt Rauschpegelbereich (P), zugeordnet wird, über den sich eine definierte beschränkte Anzahl diskreter Werte erstreckt ;

— aufeinanderfolgende Werte des Signalpegels in dem Kanal selektiert werden, welche in den genannten Rauschpegelbereich fallen,

— und eine relative Kontenführung der in diskreten Werten ausgedrückten selektierten Werte durchgeführt wird und dabei als Rauschpegelwert jener diskrete Wert genommen wird, auf den sich die Mehrheit der selektierten Werte konzentriert.

2. Verfahren zur Rauschpegelbeurteilung nach Anspruch 1, bei dem der Pegel des Signals in dem Telefonkanal durch den Amplitudenvergleich aufeinanderfolgender Signalproben, welche sich auf dem regelmäßig abgetasteten Kanal befinden, mit einem Vergleichspegelwert beurteilt wird, dadurch gekennzeichnet, daß weiter zur Beurteilung des Pegels des in dem Telefonkanal befindlichen Signals

— jedes Zeitintervall I in definierte Teilzeitintervalle unterteilt wird,

— während jedes Zeitintervalls I der Wert dieses Vergleichspegels (n) durch Kumulation, im Takt der Probenentnahme, der Variationsschritte (p) des Wertes des Vergleichspegels bestimmt wird, dessen Vorzeichen aufgrund des so durchgeführten Vergleichs definiert wird und dessen Absolutwert Funktion des betroffenen Teilzeitintervalls in dem jeweiligen Zeitintervall I ist,

— und als Wert des Signalpegels im Kanal der Vergleichspegelwert (n) am Ende jedes Zeitintervalls I genommen wird.

3. Verfahren zur Rauschpegelbeurteilung nach Anspruch 2, dadurch gekennzeichnet, daß der Absolutwert des Variationsschritts (p) in jedem Zeitinterval I einem vorherbestimmten abnehmenden Entwicklungsgesetz folgt.

4. Verfahren zur Rauschpegelbeurteilung nach Anspruch 2, dadurch gekennzeichnet, daß der Absolutwert des Variationsschritts (p) in jedem Intervall außerdem vom Absolutwert des Unterschieds zwischen der Amplitude der Probe und dem damit verglichenen Pegelwert abhängt.

5. Verfahren zur Rauschpegelbeurteilung nach Anspruch 4, dadurch gekennzeichnet, daß der Absolutwert des Variationsschrittes (p) in jedem Zeitintervall I definiert ist durch den Absolutwert des Unterschieds zwischen der Amplitude der Probe und dem damit verglichenen Pegelwert, gewichtet durch einen Proportionalitätskoeffizienten, der im Lauf des betreffenden Zeitintervalls I abnimmt.

6. Verfahren zur Rauschpegelbeurteilung nach einem der Ansprüche 2 bis 5, dadurch gekennzeichnet, daß die genannte Kumulation der Variationsschritte des Werts des Vergleichspegels b eschränkt ist zwischen einem bestimmten unteren und einem bestimmten oberen Wert, welche einen Pegelbereich unter Einschluß des genannten Rauschpegelbereichs (P) bei Überschreitung zumindest des oberen Wertes definieren.

7. Verfahren nach einem der Ansprüche 1 bis 6, dadurch gekennzeichnet, daß die relative Kontenführung der in den genannten diskreten Werten ausgedrückten selektierten Werte in der Weise durchgeführt wird, daß für jeden der genannten diskreten Werte ein Konto geführt wird, welches

— jedesmal durch einen positiven Inkrementwert modifiziert wird, wenn ein selektierter Wert gleich dem betreffenden Diskretwert ist und das auf den betreffenden diskreten Wert bezogene Konto nicht einen oberen vorbestimmten Kontenschwellwert ($R_h$) überschreitet,

— jedesmal durch einen negativen Inkrementwert modifiziert wird, wenn ein selektierter Wert gleich einem zum Betreffenden Diskretwert unterschiedlichen Diskretwert ist und das auf diesen unterschiedlichen bezogene Konto den genannten oberen Schwellwert ($R_h$) überschreitet, während das auf den betreffenden Diskretwert bezogene Konto größer als ein unterer vorbestimmter Kontenschwellwert ($R_b$) ist.

8. Verfahren zur Rauschpegelbeurteilung nach einem der Ansprüche 1 bis 7, dadurch gekennzeichnet, daß in der relativen Kontenführung der selektierten Werte jeder selektierte Wert mehr oder weniger stark gewichtet wird, je nachdem, ob er gleich dem anstehenden Wert des beurteilten Rauschpegels ist oder nicht.

9. Anordnung zur Durchführung des Verfahrens zur Beurteilung des Rauschpegels an einem Fernsprechkanal nach Anspruch 1, mit einem Schaltkreis (40) zur Beurteilung des Pegels des in dem Telefonkanal vorliegenden Signals während aufeinanderfolgender Zeitintervalle I von im wesentlichen gleicher Dauer, dadurch gekennzeichnet, daß weiter vorhanden sind :

— ein Selektionsschaltkreis (41) zur Auswahl, unter den auf der Leitung anstehenden und vom Beurteilungsschaltkreis (40) gelieferten Signalpegelwerten, nur jener Werte (N), welche in einem gegebenen dem Rauschen zugewiesenen Pegelbereich, genannt Rauschpegelbereich (P), fallen, und zur Weitergabe in Gestalt einer definierten beschränkten Gesamtheit diskreter Werte ($N_0$ bis $N_{r-1}$)

— ein Analyseschaltkreis (5) für die vom Selektionsschaltkreis (41) gelieferten selektierten Werte, welche der auf die Verteilung der genannten selektierten Werte (N) auf die r diskreten Werte ($N_0$ bis $N_{r-1}$) anspricht und jenen diskreten Wert ermittelt, auf den sich die Mehrheit der selektierten Werte konzentriert, und der an einen Ausgang (3) als repräsentativer Wert des Rauschpegels (NB) weitergegeben wird ; und

— einen Taktgeberschaltkreis (6) für den Beurteilungsschaltkreis (40) und den Selektionsschaltkreis (41) für den Pegel der auf dem Kanal befindlichen Signale sowie für den Analyseschaltkreis zur Bestimmung des Wertes des Rauschpegels im Takte der durch den Taktgeberschaltkreis definierten Zeitintervalle I.

10. Anordnung nach Anspruch 9, worin der genannte Beurteilungsschaltkreis (40) des Pegels der auf der Leitung befindlichen Signale einen Komparator (400) aufweist, welcher die Amplituden der Proben des auf den regelmäßig abgetasteten Kanal befindlichen Signalproben mit einem Wert des Vergleichspegels (n) vergleicht, dadurch gekennzeichnet, daß der genannte Pegelbeurteilungsschaltkreis (40) aus einer Regelschleife besteht, die aufweist :

— den genannten Komparator (400), der ein logisches Signal liefert, welches durch seinen Pegel anzeigt, ob die Amplitude der Probe verglichen mit dem Wert des Vergleichspegels (n) größer ist oder nicht ;

— einen Definitionschaltkreis (401) zur Definition der Variation des Vergleichspegels (n), der das logische Vergleichssignal sowie ein Sequenzsignal ($S_1$), genannt erstes Sequenzsignal, empfängt, welches von dem Taktgeberschaltkreis (6) erzeugt wird und eine Folge identischer Sequenzen ($s_1$) definiert, welche jeweils während der aufeinanderfolgenden Zeitintervalle I ablaufen, und der einen Variationsschritt (p) des durch das genannte logische Signale definierten Vorzeichens von absolut variablem Wert unter der Kontrolle des genannten ersten Sequenzsignals ($S_1$) liefert ;

— und einen Akkumulator (402), der an den Ausgang des Schaltkreises (401) zur Definition der Variation des Vergleichspegels (n) angeschlossen ist und im Takt der Probenabtastung des auf der Leitung befindlichen Signals arbeitet, um den Wert des Vergleichspegels (n) zu liefern, welcher am Ende jedes Zeitintervalls I den Wert des auf der Leitung herrschenden Signalpegels angibt.

11. Anordnung nach Anspruch 10, dadurch gekennzeichnet, daß der Akkumulator (402) einen unteren und einen oberen Anschlag aufweist, welcher für den Vergleichspegel (n) einen Variationsbereich definiert, welcher den genannten Rauschpegelbereich (P) unter Überschreitung zumindest nach oben einschließt.

12. Anordnung nach einem der Ansprüche 9 bis 11, dadurch gekennzeichnet, daß der Analyseschaltkreis (5) der selektierten Werte umfaßt :

— einen adressierbaren Speicher (50), der unter der Kontrolle eines Sequenzsignals ($S_2$), genannt zweites Sequenzsignal, und erzeugt vom Taktgeberschaltkreis (6), adressiert wird, und der für die r

diskreten Werte ($N_0$ bis $N_{r-1}$) r Konten speichert, die je die Aufteilung der vom Selektionsschaltkreis (41) selektierten Werten (N) auf die r diskrete Werte ($N_0$ bis $N_{r-1}$) vornehmen,

— einen Kontenrechenschaltkreis (51), bestehend zum einen aus einem Schaltkreis (510) für die Definition des Kosteninkrements und zum anderen aus einem Summierschaltkreis (511) mit zwei an den Ausgang des Speichers (50) bzw. des genannten Kosteninkrementdefinitionsschaltkreises (510) angeschlossenen Eingängen, sowie mit einem an den Eingang des Speichers geschalteten Ausgang ;

— einen Steuerschaltkreis (53) mit Komparatoren (530, 532, 533), welche für jeden selektierten, vom Selektionsschaltkreis (41) gelieferten Wert (N) zum einen die verschiedenen in Übereinstimmung mit der Adressierung des genannten Speichers (50) erhaltenen diskreten Werte ($N_0$ bis $N_{r-1}$) mit dem betreffenden selektiven Wert zur Identifizierung des für den selektierten Wert zuständigen Kontos vergleichen, und welche zum anderen die verschiedenen gespeicherten Konten mit einem oberen und einem unteren festgesetzten Konternschwellwert ($R_h$, $R_b$) vergleichen, wobei sie im Definitionsschaltkreis für das Konteninkrement für jeden vom Selektionsschaltkreis (41) gelieferten selektierten Wert (N) die Wahl eines positiven Inkrementwerts für das allein für den betreffenden selektierten Wert zuständige Konto steuern, wenn dieses nicht den genannten oberen Schwellwert ($R_h$) überschreitet, oder eines negativen Inkrementwertes für die anderen oberhalb des genannten unteren Schwellwertes ($R_b$) stehenden Konten, falls das entsprechende für den entsprechenden selektierten Wert zuständige Konto den genannten oberen Schwellwert ($R_h$) überschreitet, und

— einen Ausgangskreis (452) für den Rauschpegelwert, welch ersterer von dem genannten Steuerschaltkreis bei der Ermittlung des Überschreitens des genannten oberen Schwellwerts ($R_h$) durch eines der gespeicherten Konten gesteuert wird, und den betreffenden diskreten Wert von dem den genannten oberen Schwellwert übersteigenden Konto erhält.

13. Anordnung nach Anspruch 12, dadurch gekennzeichnet, daß das zweite vom genannten Taktgeberschaltkreis (6) erzeugte Sequenzsignal ($S_2$) über die Dauer jedes Zeitintervalls I zumindest zwei Sequenzen ($s_2$) definiert, deren Ablauf für die genannten r diskreten Werte repräsentativ ist, wobei die durch das zweite Sequenzsignal ($S_2$) definierten Sequenzen ($s_2$) in jedem Zeitintervall I wirksam gemacht werden, in welchem der Selektionsschaltkreis (41) einen selektierten Wert liefert, und zwar, was die erste der Sequenzen anbetrifft, zur Bestimmung in den genannten Steuerschaltkreis (53) des Standes des für den selektierten Wert zuständigen Kontos im Verhältnis zum genannten oberen Schwellwert ($R_h$), und, was die zweite der Sequenzen anbetrifft, im Gefolge der ersten, zur Aktualisierung der Konten im Speicher in Abhängigkeit vom Resultat der im Zuge der ersten Sequenz erfolgten Bestimmung, ggfs. der Stände der anderen Konten im Vergleich zum besagten unteren, im Zuge der zweiten Sequenz für jedes der noch nicht aktualisierten Konten bestimmten Schwellwerts ($R_b$).

14. Anordnung nach Anspruch 12, dadurch gekennzeichnet, daß der Steuerschaltkreis (53) mit dem Ausgang der Anordnung verbunden ist und weiter einen Komparator (531) aufweist, der jeden selektierten, vom Selektionsschaltkreis (41) gelieferten Wert (N) mit dem Wert des Rauschpegels (NB) vergleicht, welcher dann am Ausgang der Anordnung erscheint, um im Definitionsschaltkreis für das Konteninkrement die Wahl eines Konteninkrements mit mehr oder weniger großem Absolutwert zu steuern, je nachdem, ob der betreffende selektierte Wert gleich dem laufenden Wert des beurteilten Rauschpegels ist oder nicht.

15. Anordnung nach Anspruch 14, dadurch gekennzeichnet, daß das zweite, von dem Taktgeberschaltkreis (6) erzeugte Sequenzsignal über die Dauer jedes Zeitintervalls I mindestens zwei Sequenzen ($s_2$) definiert, deren Ablauf repräsentativ für jeden der r diskreten Werte ist, wobei die von der genannten zweiten Signalsequenz ($S_2$) definierten Sequenzen ($s_2$) in jedem Zeit-intervall I wirksam gemacht werden, in welchem der Selektionsschaltkreis (41) einen selektierten Wert (N) liefert, und zwar, was die erste der Sequenzen anbetrifft, zur Bestimmung in dem genannten Steuerschaltkreis (53) des Standes des für den betreffenden selektierten Wert zuständigen Kontos im Verhältnis zum genannten oberen Schwellwert ($R_h$), und zur Feststellung in dem genannten Steuerschaltkreis (53), ob dieser selektierte Wert gleich dem Wert des am Ausgang der Anordnung gelieferten Werts des Rauschpegels (NB) ist oder nicht, und, was die zweite der Sequenzen anbetrifft, im Gefolge der ersten, zur Aktualisierung von den Resulaten der im Zuge der ersten Sequenz erfolgten Bestimmung, ggfs. der Stände der anderen Konten im Vergleich zum unteren, im Zuge der zweiten Sequenz für jedes der noch nicht aktualisierten Konten bestimmten Schwellwerts ($R_b$).

# FIG.1

# FIG.2

FIG.3

FIG. 4

CIRCUIT DE
CADENCEMENT

# FIG.5

a) H

b) 0 1 2 ---- 15 16 17---31 32 ---- 47 48 ---- 63 64 ---- 79 80 ---- 95 96 ---- 111 112 ---- 127 0 ---- 15 16 ---

c) C1     I     I

d) S1 $\{$ $2^6$ $2^5$ $2^4$

e) s1 ---- 0 ---- 1 ---- 2 ---- 3 ---- 4 ---- 5 ---- 6 ---- 7 ---- 0 ---- 1

f) S2 $\{$ $2^3$ $2^2$ $2^1$ $2^0$

g) s2 ---- 15/0 - 1 --- ---- 15/0 --- 15/0 --- 15/0 --- 15/0 --- 15/0 --- 15/0 --- 15/0 --- 15/0 --- 15/0

h) V1

i) C2

j) V2

0 109 037